(19) Europäisches Patentamt
European Patent Office
Office européen des brevets

(11) EP 4 693 286 A1

(12) # EUROPEAN PATENT APPLICATION
published in accordance with Art. 153(4) EPC

(43) Date of publication:
**11.02.2026 Bulletin 2026/07**

(21) Application number: **24780650.8**

(22) Date of filing: **28.03.2024**

(51) International Patent Classification (IPC):
***G11B 7/24044*** (2013.01) ***C07C 271/48*** (2006.01)
***C08F 20/30*** (2006.01) ***C08F 20/34*** (2006.01)
***C08F 20/38*** (2006.01) ***G02B 5/32*** (2006.01)
***G03H 1/02*** (2006.01) ***G11B 7/0065*** (2006.01)
***G11B 7/245*** (2006.01)

(52) Cooperative Patent Classification (CPC):
**C07C 271/48; C08F 20/30; C08F 20/34; C08F 20/38; G02B 5/32; G03H 1/02; G11B 7/0065; G11B 7/24044; G11B 7/245**

(86) International application number:
**PCT/JP2024/012676**

(87) International publication number:
**WO 2024/204550 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2023 JP 2023053748**

(71) Applicant: **Mitsubishi Chemical Corporation**
**Tokyo 100-8251 (JP)**

(72) Inventors:
- **YAMASHITA, Shuji**
  **Tokyo 100-8251 (JP)**
- **NAKURA, Ryo**
  **Tokyo 100-8251 (JP)**
- **SATO, Ken**
  **Tokyo 100-8251 (JP)**
- **YABE, Akiko**
  **Tokyo 100-8251 (JP)**
- **INOUE, Kazuma**
  **Tokyo 100-8251 (JP)**

(74) Representative: **Hoffmann Eitle**
**Patent- und Rechtsanwälte PartmbB**
**Arabellastraße 30**
**81925 München (DE)**

(54) **PHOTOSENSITIVE COMPOSITION FOR HOLOGRAM RECORDING, HOLOGRAM RECORDING MEDIUM, POLYMER, LARGE CAPACITY MEMORY, OPTICAL ELEMENT, AR LIGHT GUIDE PLATE, AND AR GLASSES**

(57) A photosensitive composition for hologram recording, the photosensitive composition containing a photopolymerization initiator and at least two different photopolymerizable monomers that are a combination of a monofunctional photopolymerizable monomer and a polyfunctional photopolymerizable monomer. At least one of the photopolymerizable monomers is a compound represented by Formula (1-1) or (1-2) below, where $A^1$ and $A^2$ each are a photopolymerizable group; $L^1$ and $L^2$ each are a single bond or a divalent linking group that may be branched; $R^1$ and $R^2$ each are a fused aromatic ring group that may have a substituent; $m^1$ is an integer of 2 to 5; $m^2$ is an integer of 2 to 4; n is an integer of 2 to 4; when n is 2, X is a dimethylmethylene group or the like; when n is 3, X is a trivalent organic group; and when n is 4, X is a carbon atom or a silicon atom.

EP 4 693 286 A1

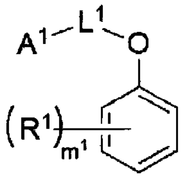

(1-1)

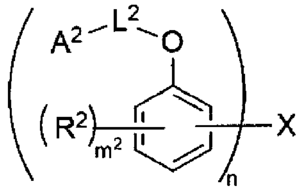

(1-2)

## Description

### Technical Field

The present invention relates to a photosensitive composition for hologram recording, the composition containing a combination of at least two different photopolymerizable monomers, and a photopolymerization initiator, the composition excelling in high transparency, easy polymerizability, and chemical stability. The present invention also relates to a hologram recording medium, a polymer, an optical material, an optical component, a large-capacity memory, an optical element, an AR light guide plate, and AR glasses, each of which uses the photosensitive composition for hologram recording.

### Background Art

Large-capacity memories including a photopolymerizable hologram material have been actively studied in the art. Irradiating a hologram recording material with interference fringes formed by interference of light allows photopolymerization to proceed at different polymerization rates in a bright part with high light intensity and in a dark part with low light intensity, thereby forming a refractive index modulation structure while accompanying diffusion and migration of substances with different refractive indices. For hologram memories used to store a large amount of data for a long period, it is strongly required that a hologram be able to be recorded at a high recording density (S/N) and that a refractive index modulation structure be stable for a long period (hereinafter referred to as archivability).

For example, as described in Patent Literature 1, a photo composition containing a photopolymerization initiator usually forms a phosphor after being exposed to light and cured. Also in photopolymerizable hologram recording materials, a phosphor derived from a recording material is known to be produced as a by-product along with the formation of a refractive index modulation structure by hologram recording. These phosphors become noise during hologram recording, reducing the recording density (S/N) and posing a major technical problem.

In recent years, studies on the use of a hologram recording material in AR glasses, which are eyeglasses enabling augmented reality (AR), have been actively conducted all over the world. AR glasses, in which an optical element with a hologram recorded is used as a light guide plate for image display, are required to be able to display an image output from a projector for a long period while achieving high color reproducibility with low power consumption. Thus, there is a strong need for a hologram recording material achieving a high refractive index modulation amount ($\Delta n$), having less optical noise, such as fluorescence, and having excellent archivability. The refractive index modulation amount ($\Delta n$) is widely used as an index of diffraction efficiency or diffraction characteristics of a hologram, and a higher $\Delta n$ value is considered to indicate better hologram characteristics.

Patent Literature 2 discloses that a hologram composition containing a fluorinated urethane in a plasticizer and a combination of different polymerizable monomers can achieve a high $\Delta n$ value. On the other hand, it is not clear whether a large refractive index modulation amount $\Delta n$ can be formed with a composition not containing a fluorinated urethane, and the archivability of $\Delta n$ and suppression of the fluorescence phenomenon are not explicitly described.

Patent Literature 3 describes that a hologram recording material with high sensitivity and high archivability can be provided by a composition containing a copolymer having a monofunctional photopolymerizable monomer characterized by a styrene-type vinyl monomer and a bifunctional monomer as structural units. However, the polymer obtained from the styrene-type vinyl monomer contains a benzyl position, which is easily oxidized. Thus, there is always a concern about low weather resistance and coloration represented by yellowing of optical materials using these.

Patent Literature 4 illustrates that a composition composed of a combination of at least two cationically polymerizable monomers including a monofunctional photopolymerizable monomer and a polyfunctional photopolymerizable monomer, a photocationic polymerization initiator, a polymerization inhibitor, and a binder resin is a recording material exhibiting an extremely high $\Delta n$ value. However, while this composition is a hologram recording composition with excellent diffraction characteristics, the polymerizable monomers used have a dinaphthothiophene structure. Thus, the composition is inherently prone to yellowing, and there is a great limitation in the use for optical materials, for which high transparency is required in the visible light region.

### Citation List

#### Patent Literature

Patent Literature 1: JP 4185939 A
Patent Literature 2: JP 2013-510204 T

Patent Literature 3: WO 2008/123094
Patent Literature 4: WO 2018/043593

Summary of Invention

Technical Problem

An object of the present invention is to provide a photosensitive composition for hologram recording, which is useful as a hologram recording medium, an optical material, or an optical component, and has high transparency, easy polymerizability, high chemical stability, and excellent archivability and low fluorescence.

Solution to Problem

The present inventor has found that introducing a specific molecular structure into at least two different photopolymerizable monomers that are a combination of a monofunctional photopolymerizable monomer and a polyfunctional photopolymerizable monomer enables improvement in the archivability and suppression of the fluorescence phenomenon while imparting high transparency, easy polymerizability, and high chemical stability. Specifically, the present inventor has found that using a composition containing at least a monofunctional or polyfunctional photopolymerizable monomer represented by Formula (1-1) or (1-2) below can provide a high-performance hologram recording medium.

The gist of the present invention resides below.

[1] A photosensitive composition for hologram recording, the photosensitive composition containing a photopolymerization initiator and at least two different photopolymerizable monomers that are a combination of a monofunctional photopolymerizable monomer and a polyfunctional photopolymerizable monomer, in which at least one of the photopolymerizable monomers is a compound selected from a compound represented by Formula (1-1) below and a compound represented by Formula (1-2) below:

[Chem. 1]

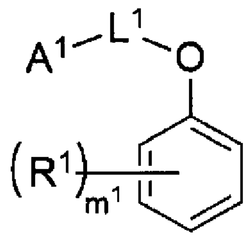

(1-1)

where in Formula (1-1), $A^1$ represents a photopolymerizable group;
$L^1$ represents a single bond or a divalent linking group that may be branched;
$R^1$ represents a fused aromatic ring group that may have a substituent;
$m^1$ is an integer of 2 to 5, and a plurality of $R^1$s may be identical or different; and
a benzene ring having $R^1$ in Formula (1-1) may further have a substituent in addition to $A^1$-$L^1$-O and $R^1$;

[Chem. 2]

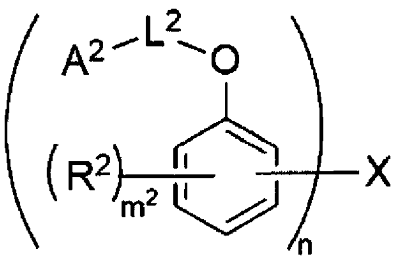

(1-2)

where in Formula (1-2), $A^2$ represents a photopolymerizable group;
$L^2$ represents a single bond or a divalent linking group that may be branched;
$R^2$ represents a fused aromatic ring group that may have a substituent;

$m^2$ is an integer of 2 to 4, and a plurality of $R^2$s may be identical or different;
n represents an integer of 2 to 4;
when n is 2, X represents a single bond or a divalent group selected from the group consisting of structures represented by Formulas (1a) to (1g) below;
when n is 3, X represents a trivalent organic group;
when n is 4, X represents a carbon atom or a silicon atom;
$A^2$, $L^2$, $R^2$, and $m^2$, each present in multiple numbers in Formula (1-2), may each be identical or different; and a benzene ring having $R^2$ in Formula (1-2) may further have a substituent in addition to $A^2$-$L^2$-O, $R^2$, and X;

[Chem. 3]

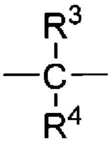
(1a)

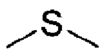
(1b)

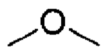
(1c)

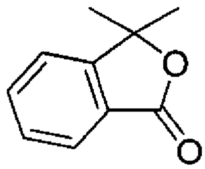
(1d)

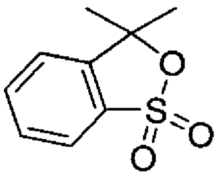
(1e)

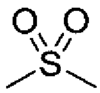
(1f)

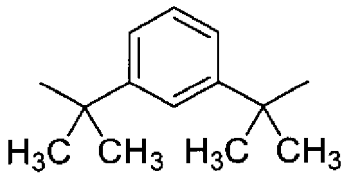
(1g)

where in Formula (1a), $R^3$ and $R^4$ each independently represent hydrogen or an alkyl group having 1 to 4 carbons.

[2] The photosensitive composition for hologram recording according to [1], in which n is 2.
[3] The photosensitive composition for hologram recording according to [1] or [2], in which $m^1$ and $m^2$ each are 2 or 3.
[4] The photosensitive composition for hologram recording according to any one of [1] to [3], in which $A^1$ and $A^2$ each are a (meth)acryloyl group or an allyl group.
[5] The photosensitive composition for hologram recording according to any one of [1] to [4], in which the fused aromatic ring of $R^1$ and $R^2$ is any one of a naphthalene ring, a phenanthrene ring, a dibenzothiophene ring, and a thianthrene ring.
[6] The photosensitive composition for hologram recording according to any one of [1] to [5], in which at least one of the monofunctional photopolymerizable monomers contains a compound represented by Formula (1-1) above, and at least one of the polyfunctional photopolymerizable monomers contains a compound represented by Formula (1-2) above.
[7] A hologram recording medium containing the photosensitive composition for hologram recording described in any one of [1] to [6].
[8] A polymer formed by polymerization of the photosensitive composition for hologram recording described in any one of [1] to [6].
[9] An optical material containing the polymer described in [8].
[10] An optical component containing the polymer described in [8].
[11] A large-capacity memory containing the hologram recording medium described in [7].
[12] An optical element obtained by hologram recording in the hologram recording medium described in [7].
[13] An AR light guide plate (waveguide plate) including the optical element described in [12].
[14] AR glasses including the optical element described in [12].

## Advantageous Effects of Invention

According to the present invention, there is provided a photosensitive composition for hologram recording, which is useful as a hologram recording material and has high transparency, high solubility, easy polymerizability, low

fluorescence, and excellent chemical stability and archivability in combination.

The photosensitive composition for hologram recording of the present invention is particularly useful as a reactive composition used in a hard coat layer of an optical lens or an optical member, and in a hologram recording medium. Using the photosensitive composition for hologram recording of the present invention can achieve an optical material or an optical component with high light transmittance, high chemical stability, and excellent processability while suppressing the fluorescence phenomenon.

Brief Description of Drawing

FIG. 1 is a schematic view illustrating an overview of a configuration of an apparatus used for hologram recording.

Description of Embodiments

Hereinafter, embodiments of the present invention will be specifically described. The present invention is not limited to the following embodiments and can be implemented with various modifications within the scope of the gist of the present invention.

In the present invention, "(meth)acrylate" is a generic term for acrylate and methacrylate. A "(meth)acryloyl group" is a generic term for an "acryloyl group" and a "methacryloyl group". The same also applies to "(meth)acryloyloxy group" and "(meth)acryl".

In the present invention, an "aromatic ring" is a generic term for an "aromatic hydrocarbon ring" and an "aromatic heterocycle". Similarly, an "aromatic ring group" is a generic term for an "aromatic hydrocarbon group" and an "aromatic heterocyclic group".

In the present invention, "may have a substituent" means that one or more substituents may be contained.

1. Composition of Present Invention

A photosensitive composition for hologram recording of the present invention (which may hereinafter be referred to as "the composition of the present invention") is a photosensitive composition containing a photopolymerization initiator and at least two different photopolymerizable monomers that are a combination of a monofunctional photopolymerizable monomer and a polyfunctional photopolymerizable monomer, characterized in that at least one of the photopolymerizable monomers is a compound selected from a compound represented by Formula (1-1) below (which may hereinafter be referred to as a "Compound (1-1)") and a compound represented by Formula (1-2) below (which may hereinafter be referred to as a "Compound (1-2)"):

[Chem. 4]

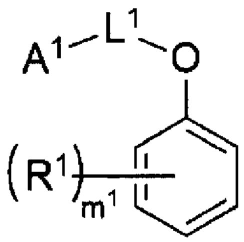

(1-1)

where in Formula (1-1), $A^1$ represents a photopolymerizable group;

$L^1$ represents a single bond or a divalent linking group that may be branched;

$R^1$ represents a fused aromatic ring group that may have a substituent;

$m^1$ is an integer of 2 to 5, and a plurality of $R^1$s may be identical or different; and

a benzene ring having $R^1$ in Formula (1-1) may further have a substituent in addition to $A^1$-$L^1$-O and $R^1$;

[Chem. 5]

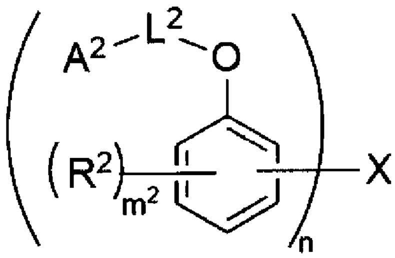

(1-2)

where in Formula (1-2), $A^2$ represents a photopolymerizable group;
$L^2$ represents a single bond or a divalent linking group that may be branched;
$R^2$ represents a fused aromatic ring group that may have a substituent;
$m^2$ is an integer of 2 to 4, and a plurality of $R^2$s may be identical or different;
n represents an integer of 2 to 4;
when n is 2, X represents a single bond or a divalent group selected from the group consisting of structures represented by Formulas (1a) to (1g) below;
when n is 3, X represents a trivalent organic group;
when n is 4, X represents a carbon atom or a silicon atom;
$A^2$, $L^2$, $R^2$, and $m^2$, each present in multiple numbers in Formula (1-2), may each be identical or different; and
a benzene ring having $R^2$ in Formula (1-2) may further have a substituent in addition to $A^2$-$L^2$-O, $R^2$, and X;

[Chem. 6]

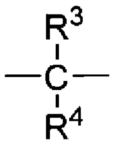

(1a)

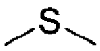

(1b)

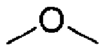

(1c)

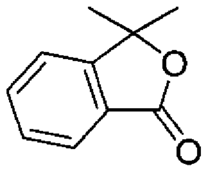

(1d)

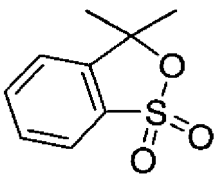

(1e)

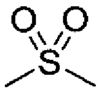

(1f)

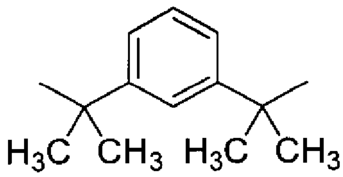

(1g)

where in Formula (1a), $R^3$ and $R^4$ each independently represent hydrogen or an alkyl group having 1 to 4 carbons.

According to the photosensitive composition for hologram recording of the present invention, obtained is a hologram recording medium with high transparency, low fluorescence, and excellent diffraction characteristics that can be stably used for a long period.

Hereinafter, the Compound (1-1) and the Compound (1-2) are collectively referred to as the "Compound (1)".

1-1. About Photopolymerizable Monomers

The at least two different photopolymerizable monomers contained in the photosensitive composition for hologram recording of the present invention are a monofunctional photopolymerizable monomer and a polyfunctional photopolymerizable monomer as described above. When two photopolymerizable monomers are contained in the composition of the present invention, one monofunctional photopolymerizable monomer and one polyfunctional photopolymerizable monomer are contained in the photosensitive composition for hologram recording. When three or more

photopolymerizable monomers are contained in the composition of the present invention, one monofunctional photopolymerizable monomer and one polyfunctional photopolymerizable monomer are contained, and one or more additional photopolymerizable monomers may be monofunctional photopolymerizable monomers or polyfunctional photopolymerizable monomers.

However, the photosensitive composition for hologram recording of the present invention necessarily contains the Compound (1) as a photopolymerizable monomer.

Among the Compounds (1), the Compound (1-1) is a monofunctional photopolymerizable monomer, and the Compound (1-2) is a polyfunctional photopolymerizable monomer.

In a first preferred embodiment of the photosensitive composition for hologram recording of the present invention, the polyfunctional photopolymerizable monomer of at least two different photopolymerizable monomers that are a combination of a monofunctional photopolymerizable monomer and a polyfunctional photopolymerizable monomer is Compound (1). In this case, the shrinkage percentage during curing tends to decrease, which is preferred.

In a second preferred embodiment of the photosensitive composition for hologram recording of the present invention, the monofunctional photopolymerizable monomer of at least two different photopolymerizable monomers that are a combination of a monofunctional photopolymerizable monomer and a polyfunctional photopolymerizable monomer is the Compound (1). In this case, the viscosity of the composition tends to decrease, thus providing excellent processability, which is preferred.

In a particularly preferred embodiment of the photosensitive composition for hologram recording of the present invention, both the monofunctional photopolymerizable monomer and the polyfunctional photopolymerizable monomer of at least two different photopolymerizable monomers that are a combination of a monofunctional photopolymerizable monomer and a polyfunctional photopolymerizable monomer are the Compounds (1). That is, the monofunctional photopolymerizable monomer is a compound represented by Formula (1-1) above, and the polyfunctional photopolymerizable monomer is a compound represented by Formula (1-2). In this case, a high refractive index modulation amount $\Delta n$ can be achieved, which is preferred.

The content of the Compound (1) in the composition of the present invention is preferably 1 mass% or more and 99 mass% or less and particularly preferably 5 mass% or more and 95 mass% or less in terms of the ratio to the total solid content of the composition of the present invention. The content of the Compound (1) less than 1 mass% would fail to sufficiently exhibit the effect of using Compound (1). The content of the Compound (1) exceeding 99 mass% would tend to reduce the curing rate.

The composition of the present invention may contain a photopolymerizable monomer besides the Compound (1) as described later. In that case, the total content of the Compound (1) and the photopolymerizable monomer other than the Compound (1) is as described later.

The content proportions of the monofunctional photopolymerizable monomer and the polyfunctional photopolymerizable monomer contained in the composition of the present invention are not particularly limited. However, relative to a total (100 mol%) of the monofunctional photopolymerizable monomer and the polyfunctional photopolymerizable monomer, the composition preferably contains from 10 to 99 mol% of the monofunctional photopolymerizable monomer and from 1 to 90 mol% of the polyfunctional photopolymerizable monomer, more preferably from 30 to 97 mol% of the monofunctional photopolymerizable monomer and from 3 to 70 mol% of the polyfunctional photopolymerizable monomer, and even more preferably from 50 to 95 mol% of the monofunctional photopolymerizable monomer and from 5 to 50 mol% of the polyfunctional photopolymerizable monomer.

When the content proportion of the monofunctional photopolymerizable monomer is not more than the upper limit of the above range and the content proportion of the polyfunctional photopolymerizable monomer is not less than the lower limit of the above range, the composition provides good hologram recording archivability, which is preferred. When the content proportion of the monofunctional photopolymerizable monomer is not less than the lower limit of the above range and the content proportion of the polyfunctional photopolymerizable monomer is not more than the upper limit of the above range, the viscosity of the composition is less likely to increase, which is preferred.

1-2-1. About Structure of Compound (1)

The Compound (1-1) is characterized by having a partial structure in which two or more fused aromatic ring groups $R^1$ are attached to a benzene ring substituted with a photopolymerizable group $A^1$ via an oxygen atom and a single bond or a linking group $L^1$ (which may hereinafter be referred to as a "phenoxy ring" or a "phenoxy backbone").

Similarly, the Compound (1-2) is characterized by having a partial structure in which two or more fused aromatic ring groups $R^2$ are attached to a benzene ring substituted with a photopolymerizable group $A^2$ via an oxygen atom and a single bond or a linking group $L^2$ (which may hereinafter be referred to as a "phenoxy ring" or a "phenoxy backbone").

In hologram materials, a high-refractive-index polymerizable monomer is often used to improve the refractive index modulation amount $\Delta n$, and an organic compound having an aromatic ring group is sometimes used to improve the refractive index. However, an organic compound having an aromatic ring group with high planarity usually has poor

solubility in various solvents and thus is difficult to be used to prepare a high-concentration solution to achieve a high refractive index or a high Δn value. In addition, even when a high-concentration solution can be prepared, such a solution has a problem that the high crystallinity of the organic compound facilitates its own precipitation from the stock solution over time. In particular, aromatic organic compounds used in optical materials with a refractive index exceeding 1.65 have a plurality of aromatic rings as substituents and tend to have lower solubility in various solvents as the molecular weight increases.

The Compound (1) is characterized by having, as a partial structure, a phenoxy backbone densely linked with a large number of fused aromatic ring groups $R^1$ or $R^2$. This causes molecular torsion between the substituents on the phenoxy backbone and can significantly reduce the crystallinity of the Compound (1). In particular, replacing the phenoxy backbone by a larger number of fused aromatic ring groups $R^1$ or $R^2$ with a high refractive index also increases the molecular weight of the Compound (1) along with an increase in its refractive index but also tends to reduce the symmetry and planarity of the entire molecule, and can provide high solubility in solvents. In the Compound (1) with a large molecular weight, the (meth)acryl group concentration in the monomer relatively decreases particularly when the photopolymerizable groups $A^1$ and $A^2$ are (meth)acryloyl groups. This makes the composition very useful also as a hologram recording material with small shrinkage during curing.

In addition, attaching the photopolymerizable groups $A^1$ or $A^2$ to appropriate positions away from the high-refractive-index site with large steric hindrance via the linking groups $L^1$ or $L^2$ allows the photopolymerizable groups $A^1$ and $A^2$ to exhibit high polymerizability while significantly improving the flexibility of the Compound (1). This can achieve a higher refractive index and improved chemical stability of the resulting polymer.

Furthermore, as described later, the photopolymerizable groups $A^1$ or $A^2$ are attached via the linking groups $L^1$ or $L^2$ to the phenoxy backbone substituted with a large number of fused aromatic ring groups $R^1$ or $R^2$. Thus, this suppresses the fluorescence phenomenon derived from the photopolymerization initiator and can reduce the fluorescence.

1-2-2. About Formulas (1-1) and (1-2)

$L^1$ and $L^2$ represent a single bond or a divalent linking group that may be branched. $L^1$ and $L^2$ may have an oxygen atom or a sulfur atom, or a nitrogen atom that may have a substituent. In the Compound (1-2), a plurality of $L^2$s are present; each $L^2$ may be identical or different.

The linking group constituting $L^1$ and $L^2$ is preferably an aliphatic hydrocarbon group that may have a substituent from the viewpoints of ease of synthesis and ease of availability. The aliphatic hydrocarbon group preferably has from 1 to 8 carbons (not including carbons in the substituent). When the aliphatic hydrocarbon group has 8 or less carbons, the refractive index of the Compound (1) is less likely to decrease. Furthermore, its small molecular weight leads to reduced viscosity, tending to improve the processability. The aliphatic hydrocarbon group constituting $L^1$ and $L^2$ may be a cyclic aliphatic hydrocarbon group or a chain aliphatic hydrocarbon group, or may be a combination of these structures. In terms of alleviating the steric hindrance around the photopolymerizable group $A^1$ or $A^2$, a chain aliphatic hydrocarbon group is preferred.

From the viewpoint of imparting high solubility in various media in the Compound (1), $L^1$ and $L^2$ each are preferably a linking group having an oxygen atom or a sulfur atom, or a nitrogen atom that may have a substituent. These linking groups may have a substituent and preferably have from 1 to 8 carbons (not including carbons in the substituent). When the linking group has 8 or less carbons, the refractive index of the Compound (1) is less likely to decrease. Furthermore, its small molecular weight leads to reduced viscosity, tending to improve the processability. The linking group constituting $L^1$ and $L^2$ may be a cyclic linking group or a chain linking group, or may be a combination of these structures. In terms of alleviating the steric hindrance around the photopolymerizable group $A^1$ or $A^2$, a chain linking group is preferred.

Examples of the chain linking group constituting $L^1$ and $L^2$ and having an oxygen atom or a sulfur atom, or a nitrogen atom that may have a substituent include $-CH_2CH_2OCH_2CH_2-$, $-CH_2CH_2OCH_2CH_2OCH_2CH_2-$, $-CH_2CH_2SCH_2CH_2-$, $-CH_2CH_2(CO)-$, $-CH_2CH_2CH_2(CO)-$, $-CH_2CH_2CH_2CH_2(CO)-$, $-CH_2CH_2CH_2CH_2CH_2(CO)-$, $-CH_2CH_2OCH_2CH_2(CO)-$, $-CH_2CH_2NH(CO)-$, $-CH_2CH_2CH_2NH(CO)-$, $-CH_2CH_2CH_2CH_2NH(CO)-$, $-CH_2CH_2OCH_2CH_2NH(CO)-$, $-OCH_2CH_2-$, $-OCH_2CH_2OCH_2CH_2-$, $-OCH_2CH_2OCH_2CH_2OCH_2CH_2-$, $-OCH_2CH_2SCH_2CH_2-$, $-OCH_2CH_2(CO)-$, $-OCH_2CH_2CH_2(CO)-$, $-OCH_2CH_2CH_2CH_2(CO)-$, $-OCH_2CH_2CH_2CH_2CH_2(CO)-$, $-OCH_2CH_2OCH_2CH_2(CO)-$, $-OCH_2CH_2NH(CO)-$, $-OCH_2CH_2CH_2NH(CO)-$, $-OCH_2CH_2CH_2CH_2NH(CO)-$, and $-OCH_2CH_2OCH_2CH_2NH(CO)-$.

$L^1$ and $L^2$ preferably contain a cyclic group from the viewpoint of a high refractive index, and the ring contained in the cyclic group constituting $L^1$ and $L^2$ may be a monocyclic structure or a fused ring structure. $L^1$ and $L^2$ each contain preferably from 1 to 4 rings, more preferably from 1 to 3 rings, and even more preferably 1 or 2 rings. The rings contained in $L^1$ and $L^2$ need not necessarily be aromatic but are preferably aromatic hydrocarbon rings to maintain a high refractive index while keeping a small size relative to the overall molecule. Examples of the aromatic hydrocarbon ring constituting $L^1$ and $L^2$ include a benzene ring, an indene ring, a naphthalene ring, an azulene ring, a fluorene ring, an acenaphthylene ring, an anthracene ring, a phenanthrene ring, and a pyrene ring.

The linking groups $L^1$ and $L^2$ may each have a substituent. Examples of the substituent that $L^1$ and $L^2$ may each have include a halogen atom (a chlorine atom, a bromine atom, and an iodine atom), a hydroxy group, a mercapto group, an alkyl group having 1 to 8 carbons, an alkenyl group having 2 to 8 carbons, an alkoxy group having 1 to 8 carbons, a phenyl group, a mesityl group, a tolyl group, a naphthyl group, a cyano group, an acetyloxy group, an alkylcarbonyloxy group having 2 to 9 carbons, an alkoxycarbonyl group having 2 to 9 carbons, a sulfamoyl group, an alkylsulfamoyl group having 2 to 9 carbons, an alkylcarbonyl group having 2 to 9 carbons, a phenethyl group, a hydroxyethyl group, an acetylamide group, a dialkylaminoethyl group to which an alkyl group having 1 to 4 carbons is attached, a trifluoromethyl group, an alkylthio group having 1 to 8 carbons, an aromatic ring thio group having 6 to 10 carbons, and a nitro group.

1-2-3. About $R^1$ and $R^2$ in Formulas (1-1) and (1-2)

$R^1$ and $R^2$ each represent a fused aromatic ring group that may have a substituent. The fused aromatic ring of the fused aromatic ring group is broadly classified into a fused aromatic hydrocarbon ring and a fused aromatic heterocycle.
Examples of the fused aromatic hydrocarbon ring include a naphthalene ring, a phenanthrene ring, a perylene ring, a tetracene ring, a pyrene ring, a benzpyrene ring, a chrysene ring, a triphenylene ring, an acenaphthene ring, a fluoranthene ring, a fluorene ring, and an anthracene ring.
From the viewpoints of ease of synthesis and ease of availability, the fused aromatic hydrocarbon ring constituting $R^1$ and $R^2$ is preferably a naphthalene ring, a phenanthrene ring, a pyrene ring, or a fluorene ring. From the viewpoint of suppressing fluorescence of the Compound (1), the fused aromatic hydrocarbon ring constituting $R^1$ and $R^2$ is more preferably a naphthalene ring, a phenanthrene ring, or a fluorene ring.
The fused aromatic heterocycle constituting $R^1$ and $R^2$ is preferably a fused sulfur-containing aromatic heterocycle because it tends to be able to increase the refractive index of the Compound (1). The fused sulfur-containing aromatic heterocycle has at least a sulfur atom as a heteroatom constituting the fused aromatic heterocycle. In addition to a sulfur atom as a heteroatom, the fused sulfur-containing aromatic heterocycle may have an oxygen atom, a nitrogen atom, or an oxygen atom and a nitrogen atom. From the viewpoints of avoiding coloration and ensuring solubility, the number of heteroatoms constituting the fused sulfur-containing aromatic heterocycle is preferably from 1 to 3 and more preferably 1 or 2.
Examples of the fused sulfur-containing aromatic heterocycle include fused aromatic heterocycles containing one sulfur atom, such as a benzothiophene ring, a dibenzothiophene ring, a benzonaphthothiophene ring, a dinaphthothiophene ring, a naphthothiophene ring, a dinaphthothiophene ring, and a dibenzothiopyran ring; fused aromatic heterocycles containing two or more sulfur atoms, such as a thianthrene ring; and fused aromatic heterocycles containing two or more heteroatoms, such as a benzothiazole ring, a naphthothiazole ring, a phenothiazine ring, a thiazoloimidazole ring, a thiazolopyridine ring, a thiazolopyridazine ring, a thiazolopyrimidine ring, a dioxazolopyrazine ring, a thiazolopyrazine ring, a thiazolooxazole ring, a dibenzobenzothiophene ring, a thienooxazole ring, a thienothiadiazole ring, and a thiazolothiadiazole ring.
The number of rings constituting the fused sulfur-containing aromatic heterocycle is preferably from 2 to 8, more preferably from 2 to 6, and in terms of easy availability of raw materials and easy synthesis, particularly preferably from 2 to 5.
In particular, in terms of higher refractive index and low colorability, the fused sulfur-containing aromatic heterocycle is preferably a benzothiazole ring, a dibenzothiophene ring, a benzothiophene ring, a benzonaphthothiophene ring, or a thianthrene ring.
The fused aromatic heterocycle constituting $R^1$ and $R^2$ may be a fused nitrogen-containing aromatic heterocycle from the viewpoint of ease of synthesis. The fused nitrogen-containing aromatic heterocycle has at least a nitrogen atom as a heteroatom constituting the fused aromatic heterocycle. In addition to a nitrogen atom as a heteroatom, the fused nitrogen-containing aromatic heterocycle may have an oxygen atom, a sulfur atom, or an oxygen atom and a nitrogen atom. From the viewpoint of avoiding coloration, the number of heteroatoms constituting the fused nitrogen-containing aromatic heterocycle is preferably from 1 to 3 and more preferably 1 or 2.
Examples of the fused nitrogen-containing aromatic heterocycle include fused aromatic heterocycles containing one nitrogen atom, such as an indole ring, a carbazole ring, a benzocarbazole ring, a dibenzocarbazole ring, a quinoline ring, an isoquinoline ring, a benzoxazole ring, a naphthoxazole ring, a benzothiazole ring, a naphthothiazole ring, a phenoxazine ring, a phenothiazine ring, a thienooxazole ring, a thiazolooxazole ring, an oxazolooxazole ring, a furothiazole ring, a thienothiazole ring, and a thiazolothiazole ring; and fused aromatic heterocycles containing two or more nitrogen atoms, such as a benzimidazole ring, an oxazoloimidazole ring, an oxazolopyridine ring, an oxazolopyridazine ring, an oxazolopyrimidine ring, an oxazolopyrazine ring, a quinolinooxazole ring, a dioxazolopyrazine ring, a thiazoloimidazole ring, a thienothiadiazole ring, a thiazolothiadiazole ring, a thiazolopyridine ring, a thiazolopyridazine ring, a thiazolopyrimidine ring, a thiazolopyrazine ring, and a quinolinothiazole ring.
The number of rings constituting the fused nitrogen-containing aromatic heterocycle is preferably from 2 to 8, more preferably from 2 to 6, and in terms of easy availability of raw materials and easy synthesis, particularly preferably

from 2 to 5.

In particular, in terms of higher refractive index and low colorability, the fused nitrogen-containing aromatic heterocycle is preferably a carbazole ring, a benzocarbazole ring, a dibenzocarbazole ring, a quinoline ring, an isoquinoline ring, a benzoxazole ring, a benzothiazole ring, a benzimidazole ring, or a thiadiazole ring, and more preferably a carbazole ring, a benzocarbazole ring, a dibenzocarbazole ring, a benzoxazole ring, a benzothiazole ring, a benzimidazole ring, or a thiadiazole ring.

The fused aromatic heterocycle constituting $R^1$ and $R^2$ may be a fused oxygen-containing aromatic heterocycle. The fused oxygen-containing aromatic heterocycle tends to improve the heat resistance and weather resistance of a polymer containing the Compound (1). The fused oxygen-containing aromatic heterocycle has at least an oxygen atom as a heteroatom constituting the fused aromatic heterocycle. In addition to an oxygen atom as a heteroatom, the fused oxygen-containing aromatic heterocycle may have a nitrogen atom, a sulfur atom, or a nitrogen atom and a sulfur atom. From the viewpoint of ensuring heat resistance, the number of oxygen atoms constituting the fused oxygen-containing aromatic heterocycle is preferably from 1 to 3 and more preferably 1 or 2.

Examples of the fused oxygen-containing aromatic heterocycle include fused aromatic heterocycles containing one oxygen atom, such as a benzofuran ring, a dibenzofuran ring, a naphthofuran ring, a benzonaphthofuran ring, a dinaphthofuran ring, a phenoxazine ring, an oxazole ring, an isoxazole ring, a benzoxazole ring, a benzisoxazole ring, a naphthoxazole ring, a thienooxazole ring, a thiazoloxazole ring, an oxazoloimidazole ring, and a furothiazole ring; and fused aromatic heterocycles containing two or more oxygen atoms, such as a dibenzodioxin ring, an oxazolooxazole ring, and a dioxazolopyrazine ring.

The number of rings constituting the fused oxygen-containing aromatic heterocycle is preferably from 2 to 8, more preferably from 2 to 6, and in terms of easy availability of raw materials and easy synthesis, particularly preferably from 2 to 5.

In particular, in terms of higher refractive index and low colorability, the fused oxygen-containing aromatic heterocycle is preferably a dibenzofuran ring, a benzonaphthofuran ring, a dinaphthofuran ring, an oxazole ring, an isoxazole ring, a benzoxazole ring, a benzisoxazole ring, or a naphthoxazole ring, and more preferably a dibenzofuran ring, a benzonaphthofuran ring, a dinaphthofuran ring, or a benzoxazole ring.

The fused aromatic ring constituting these $R^1$ and $R^2$ may have a substituent. Examples of the substituent that the fused aromatic ring may have include a halogen atom, such as chlorine, bromine, and iodine; an alkyl group having 1 to 8 carbons; an alkenyl group having 2 to 8 carbons; an alkynyl group having 2 to 8 carbons; an alkoxyl group; a cyano group; an acetyloxy group; an alkylcarbonyloxy group having 2 to 9 carbons; an alkoxycarbonyl group having 2 to 9 carbons; a sulfamoyl group; an alkylsulfamoyl group having 2 to 9 carbons; an alkylcarbonyl group having 2 to 9 carbons; a phenethyl group; a hydroxyethyl group; an acetylamide group; a dialkylaminoethyl group in which alkyl groups having 1 to 4 carbons are bonded; a trifluoromethyl group; an alkylthio group having 1 to 8 carbons; an aromatic ring thio group having 6 to 10 carbons; and a nitro group. Among others, examples preferably include an alkyl group having 1 to 8 carbons, an alkoxyl group having 1 to 8 carbons, an alkylthio group having 1 to 8 carbons, an aromatic ring thio group having 6 to 10 carbons, a cyano group, an acetyloxy group, an alkylcarboxyl group having 2 to 8 carbons, a sulfamoyl group, an alkylsulfamoyl group having 2 to 9 carbons, and a nitro group.

The fused aromatic ring constituting these $R^1$ and $R^2$ preferably has a group further containing an aromatic ring as a substituent from the viewpoint of increasing the refractive index of the Compound (1). Examples of the aromatic ring contained in the substituent include a benzene ring, a furan ring, a thiophene ring, a pyrrole ring, and a pyridine ring, in addition to the fused aromatic ring constituting $R^1$ and $R^2$. The aromatic ring contained in these substituents may be attached directly to the fused aromatic ring constituting $R^1$ or $R^2$ at any position, may be attached via an oxygen atom or a sulfur atom, or a nitrogen atom that may have a substituent, or may be attached via any linking group. The substituent is more preferably directly attached to the fused aromatic ring constituting $R^1$ or $R^2$.

In addition, using the sulfur-containing aromatic heterocycle as the aromatic ring contained in this substituent tends to further increase the refractive index of the Compound (1). The definition of the sulfur-containing aromatic heterocycle is the same as that in $R^1$ and $R^2$. The sulfur-containing aromatic heterocycle is more preferably a fused sulfur-containing aromatic heterocycle and particularly preferably a benzothiazole ring, a dibenzothiophene ring, a benzothiophene ring, a benzonaphthothiophene ring, a dinaphthothiophene ring, or a thianthrene ring.

The number of aromatic rings that $R^1$ or $R^2$ has as substituents is not particularly limited, but from the viewpoints of ease of synthesis and solubility, the number is preferably from 1 to 4 and more preferably 1 or 2.

In terms of satisfying both high refractive index and high solubility in various media, the fused aromatic ring that constitutes $R^1$ or $R^2$ and may have a substituent is preferably a naphthalene ring, a fluorene ring, a thianthrene ring, a phenanthrene ring, or a dibenzothiophene ring, more preferably a dibenzothiophene ring or a phenanthrene ring, and particularly preferably a naphthalene ring, a phenanthrene ring, a dibenzothiophene ring, or a thianthrene ring.

The fused aromatic ring constituting $R^1$ or $R^2$ may have two or more selected from the fused aromatic hydrocarbon rings, fused sulfur-containing aromatic heterocycles, fused nitrogen-containing aromatic heterocycles, and fused oxygen-containing aromatic heterocycles described above.

As described later, $R^1$ and $R^2$ each are present in multiple numbers because $m^1$ is from 2 to 4 and $m^2$ is 3 or 4; a plurality of $R^1$s and $R^2$s may each be identical or different.

1-2-4. About $m^1$ and $m^2$ in Formulas (1-1) and (1-2)

$m^1$ represents an integer of 2 to 5. $m^2$ represents an integer of 2 to 4. These $m^1$ and $m^2$ can be appropriately selected. For example, from the viewpoints of ease of synthesis of the Compound (1) and ease of availability of raw materials, $m^1$ is preferably 2 or 3 and more preferably 3. $m^2$ is preferably 2 or 3.

n in Formula (1-2) is an integer of 2 to 4, and groups $(R^2)_{m2}$ are present in multiple numbers; $R^2$ and $m^2$ of each group $(R^2)_{m2}$ may be identical or different, respectively.

1-2-5. About n and X in Formula (1-2)

n represents an integer of 2 to 4.

When n is 2, X represents a single bond or a divalent group selected from the group consisting of structures represented by Formulas (1a) to (1g) below.

When n is 3, X represents a trivalent organic group.

When n is 4, X represents a carbon atom or a silicon atom.

[Chem. 7]

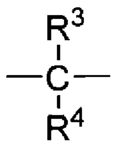
(1a)

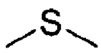
(1b)

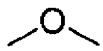
(1c)

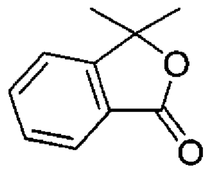
(1d)

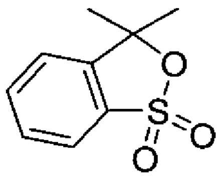
(1e)

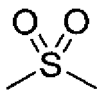
(1f)

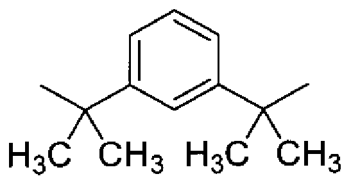
(1g)

where in Formula (1a), $R^3$ and $R^4$ each independently represent hydrogen or an alkyl group having 1 to 4 carbons.

From the viewpoints of ease of synthesis of the Compound (1-2) and ease of availability of raw materials, n is preferably an integer of 2 or 3 and more preferably 2.

When n is 2, from the viewpoint of the higher refractive index of the Compound (1-2), X is preferably a single bond, or a divalent oxygen atom or sulfur atom. X is more preferably a single bond from the viewpoint of the chemical stability of an intermediate compound. In addition, from the viewpoints of suppression of coloration of the Compound (1-2), ease of synthesis, and ease of availability of raw materials, X is particularly preferably a dimethylmethylene group (in Formula (1a) above, $R^3$ and $R^4$ are methyl groups), a phthalidenylene group (Formula (1d) above), or a sulfonyl group (Formula (1f) above).

When n is 3, X is preferably a methylmethine group or a methine group from the viewpoint of ease of availability of raw materials.

When n is 4, X is preferably a carbon atom from the viewpoint of compound stability.

1-2-6. About $A^1$ and $A^2$ in Formulas (1-1) and (1-2)

$A^1$ and $A^2$ represent a photopolymerizable group. The photopolymerizable group is a group that has polymerizability by a photopolymerization initiator, and examples include an oxiranyl group, an oxetanyl group, a vinyl group, an allyl group, and a (meth)acryloyl group. Among these, an allyl group or a (meth)acryloyl group is preferred from the viewpoint of

ease of synthesis, and a (meth)acryloyl group is particularly preferred from the viewpoint of high reactivity.
In the Compound (1-2), $A^2$ are present in multiple numbers; each $A^2$ may be identical or different.

1-2-7. About Substituents Other Than $R^1$, $R^2$, and X that Phenoxy Ring in the Compound (1) Has

The phenoxy ring in the Compound (1) may have a substituent other than $R^1$.
The phenoxy ring in the Compound (2) may have a substituent other than $R^2$ and X.
Examples of the substituent that this phenoxy group may have include a halogen atom, such as fluorine, chlorine, bromine, and iodine; an alkyl group having 1 to 8 carbons; an alkenyl group having 2 to 8 carbons; an alkynyl group having 2 to 8 carbons; an alkoxyl group; a cyano group; an acetyloxy group; an alkylcarbonyloxy group having 2 to 9 carbons; an alkoxycarbonyl group having 2 to 9 carbons; a sulfamoyl group; an alkylsulfamoyl group having 2 to 9 carbons; an alkylcarbonyl group having 2 to 9 carbons; a phenethyl group; a hydroxyethyl group; an acetylamide group; a dialkylaminoethyl group in which alkyl groups having 1 to 4 carbons are bound; a trifluoromethyl group; an alkylthio group having 1 to 8 carbons; an aromatic ring thio group having 6 to 10 carbons; and a nitro group.
From the viewpoint of ease of synthesis, the phenoxy ring preferably has no substituent other than $R^1$ or $R^2$ and X. On the other hand, from the viewpoint of improving the refractive index and solubility, the phenoxy ring preferably has, as a substituent, an alkyl group having 1 to 8 carbons, an alkoxyl group having 1 to 8 carbons, an alkylthio group having 1 to 8 carbons, an aromatic ring thio group having 6 to 10 carbons, a cyano group, an acetyloxy group, an alkylcarboxyl group having 2 to 8 carbons, a sulfamoyl group, an alkylsulfamoyl group having 2 to 9 carbons, or a nitro group.

1-2-8. Molecular Weight of Compound (1)

From the viewpoints of keeping the viscosity of the composition of the present invention low and keeping good processability, the Compound (1) has a molecular weight of preferably 2500 or less, more preferably 2200 or less, and even more preferably 2000 or less,. From the viewpoint of reducing the shrinkage percentage during polymerization, the Compound (1) has a molecular weight of preferably 500 or more, more preferably 600 or more, and even more preferably 700 or more.
In particular, the molecular weight of the Compound (1-1), which is a monofunctional photopolymerizable monomer, is preferably 2000 or less, more preferably 1800 or less, even more preferably 1500 or less, preferably 500 or more, more preferably 600 or more, and even more preferably 700 or more.
The molecular weight of the Compound (1-2), which is a polyfunctional photopolymerizable monomer, is preferably 2500 or less, more preferably 2200 or less, even more preferably 2000 or less, preferably 500 or more, more preferably 600 or more, and even more preferably 700 or more.

1-2-9. Relationship between Molecular Structure and Physical Properties of Compound (1)

The Compound (1) can appropriately introduce molecular torsion into the monomer and the polymer by attaching two or more high-planarity fused aromatic ring groups $R^1$ or $R^2$ to the phenoxy backbone, the molecular torsion with a dihedral angle of one degree or more at the junction between the phenoxy ring and the fused aromatic ring groups $R^1$ or $R^2$. In particular, the dihedral angle tends to increase when the fused aromatic ring groups $R^1$ or $R^2$ are fused aromatic ring groups having a substituent or a ring structure at the ortho position of the junction with the phenoxy ring as represented by a 9-naphthalenyl group, a 9-phenanthrenyl group, a 1-thianthrenyl group, a 4-dibenzofuranyl group, and a 4-dibenzothiophenyl group. This achieves high solubility in various media while suppressing aggregation of the high-refractive-index structure, enabling the polymerizable monomer to be used as one with an ultra-high refractive index.
In addition, the molecular torsion has an effect of preventing or reducing excessive conjugate elongation of the fused aromatic ring group $R^1$ or $R^2$ with the phenoxy ring and suppressing an increase in the absorption wavelength of the Compound (1). This makes it possible, for example, to achieve an optical material that is colorless and transparent in the visible light region and improved compound stability against heating, light irradiation, oxidation, and the like.
Furthermore, in the development of a high-refractive-index material, it is very important to improve the electron density per volume in a monomer and a polymer, that is, to shorten the intermolecular distance, for improving the refractive index. For the Compound (1), introduction of a linker with appropriate molecular length into the high-refractive-index structure of sterically bulky fused aromatic ring groups $R^1$ and $R^2$ is contemplated to shorten the intermolecular distance by intermolecular interactions, such as van der Waals forces and hydrogen bonding, relative to that in a derivative lacking the linker. From this, the same high-refractive-index structure can be expected to exhibit an even higher refractive index.
In addition, as described in the "Background Art" section above, in a photo composition, a phosphor derived from a photopolymerization initiator is known to be produced as a by-product along with the progress of polymerization by exposure to light. This is considered to be derived from a molecular structure introduced into the photopolymerization initiator so as to enable activation by irradiation light, the molecular structure easily absorbing ultraviolet light and/or visible

light. The absorption structures of these photopolymerization initiators are incorporated mainly into the polymer end through activation and/or decomposition by exposure to light. However, in a medium in which curing has progressed, molecular motion is very slow compared with a solution state, and thus overlapping between absorption structures due to π-π interaction and the like can be stabilized. It is generally considered that this results in exhibiting a stronger fluorescence phenomenon along with the progress of polymerization and/or curing.

The photopolymerizable group $A^1$ or $A^2$ of the Compound (1) is attached through the linking group L to the phenoxy backbone substituted with a large number of fused aromatic ring groups $R^1$ or $R^2$ as described above. This places the photopolymerizable group $A^1$ or $A^2$ in an environment spatially covered with the fused aromatic ring substituents $R^1$ or $R^2$. When the photopolymerization initiator activated by exposure to light and the photopolymerizable group $A^1$ or $A^2$ of the Compound (1) are bonded, the fused aromatic rings of $R^1$ or $R^2$ of the Compound (1) shield the absorption structure derived from the photopolymerization initiator incorporated into the polymer end, and this tends to inhibit the intermolecular interaction between the absorption structures. This is considered to have enabled the suppression of the fluorescence phenomenon derived from the photopolymerization initiator in the composition of the present invention containing the Compound (1) as a photopolymerizable monomer.

It is considered that in the composition of the present invention, in which the monofunctional and polyfunctional photopolymerizable monomers coexist in a mixed manner, the activated photopolymerization initiator can be attached to the photopolymerizable group $A^1$ or $A^2$ in various environments, and thus the overlap between the absorption structures of the photopolymerization initiator due to the π-π interaction and the like is greatly reduced.

1-2-10. Exemplary Compounds of Compound (1)

Specific examples of the Compound (1) are shown below. The Compound (1) contained in the photosensitive composition of the present invention is not limited to these as long as the gist of the present invention is not deviated. In the following, Et represents an ethyl group.

[Chem. 8]

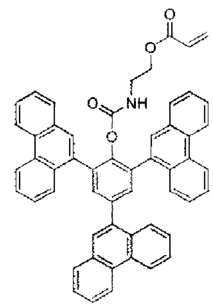
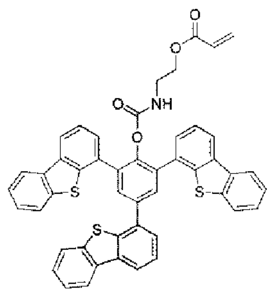
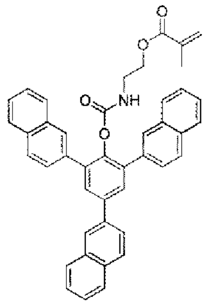
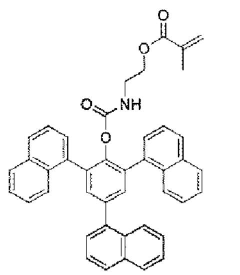
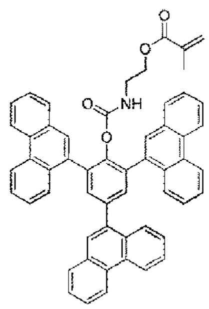
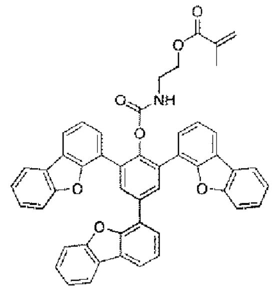
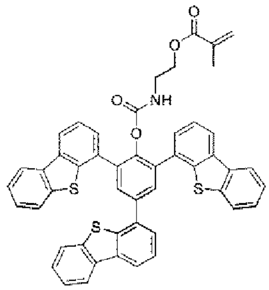
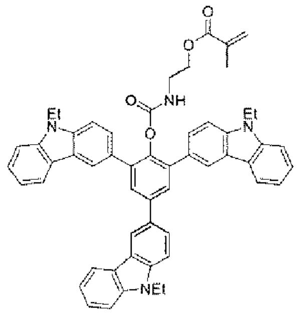
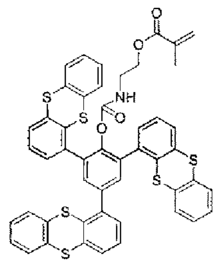
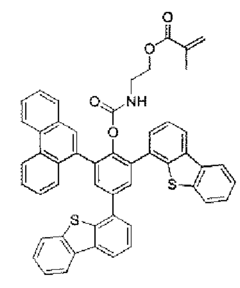
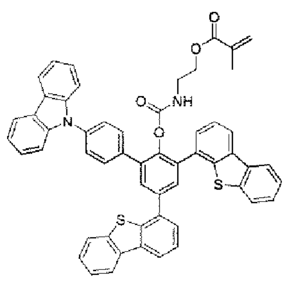
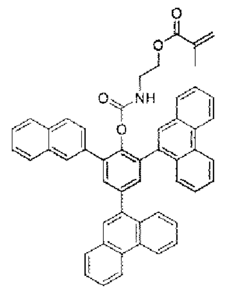
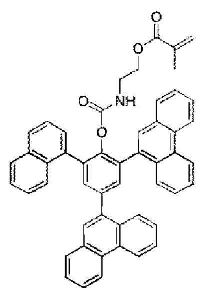
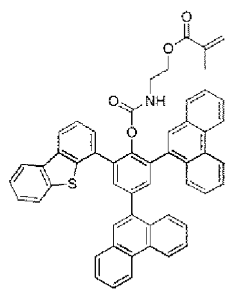
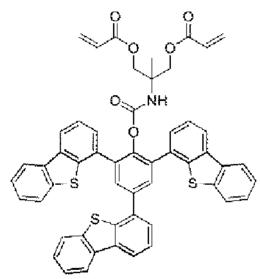
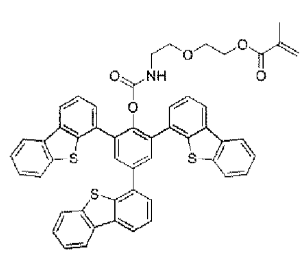

[Chem. 9]

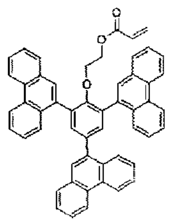
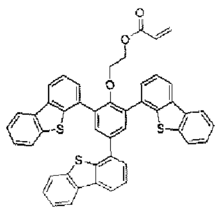
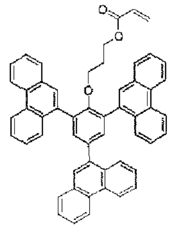
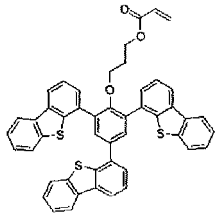

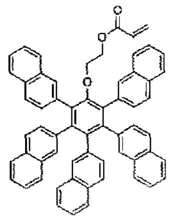
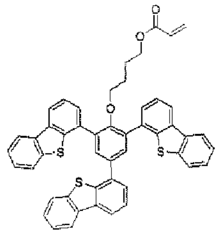
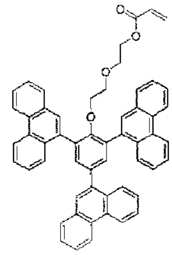
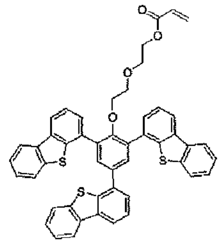

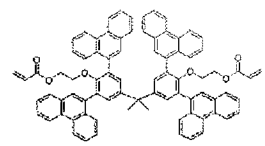
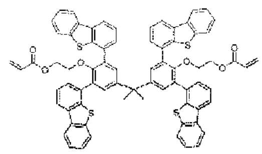
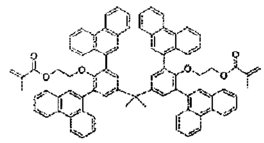
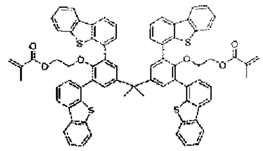

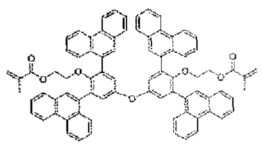
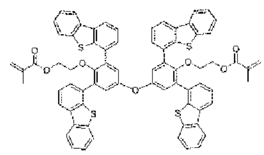
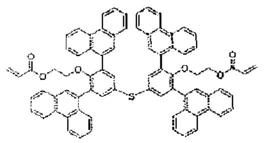
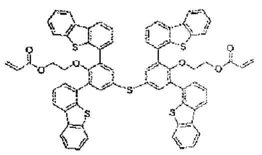

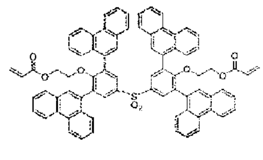
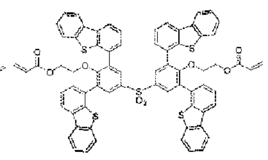
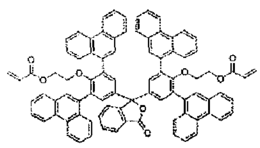
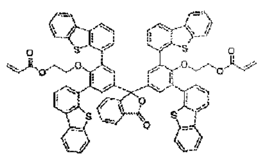

[Chem. 10]

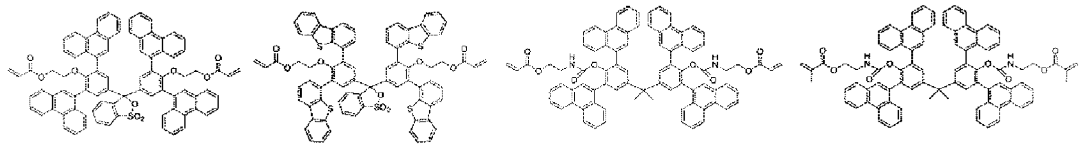

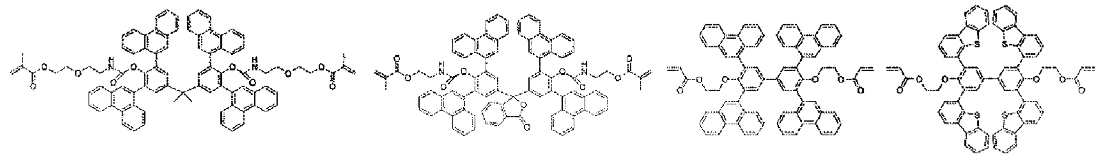

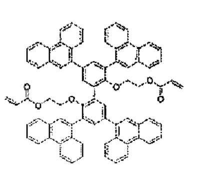

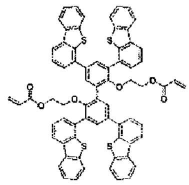

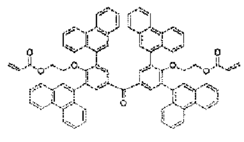

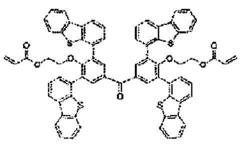

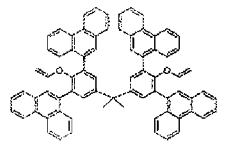

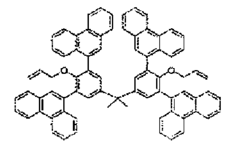

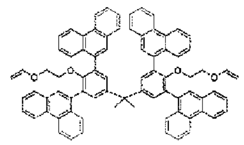

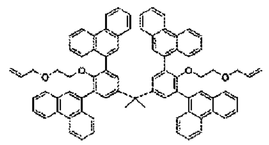

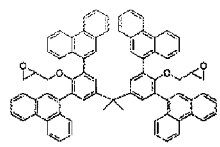

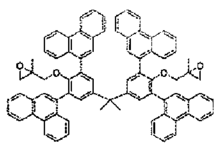

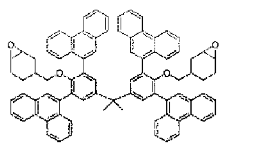

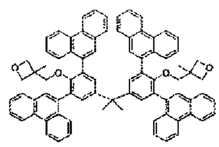

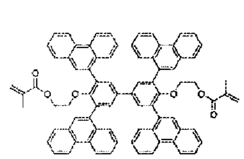

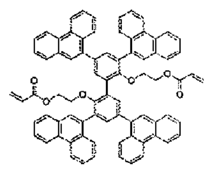

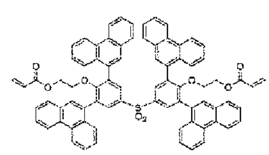

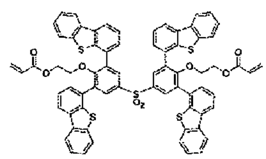

[Chem. 11]

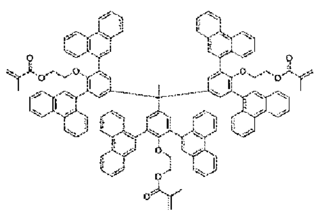

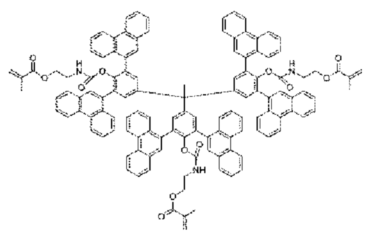

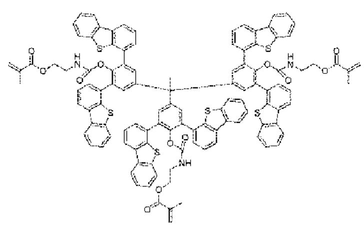

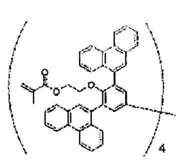

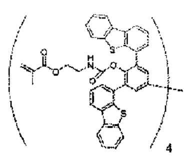

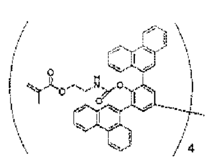

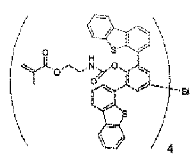

1-2-11. About Synthesis Method of Compound (1)

The Compound (1) can be synthesized by combining various known methods. For example, the Compound (1) can be synthesized by a reaction of a compound represented by Formula (2) below (which may hereinafter be referred to as "Compound (2)") with a compound having a group capable of reacting with a hydroxy group.

[Chem. 12]

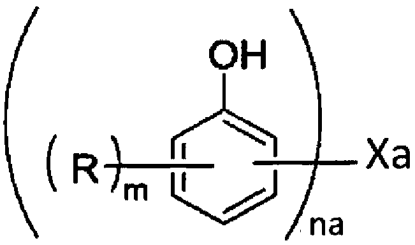

(2)

where in Formula (2), R corresponds to $R^1$ in Formula (1-1) above and $R^2$ in Formula (1-2); m corresponds to $m^1$ in Formula (1-1) and $m^2$ in Formula (1-2); na is 1 in producing the Compound (1-1) and represents an integer of 2 to 4 in producing the Compound (1-2); Xa is a hydrogen atom or $R^1$ in producing the Compound (1-1) and corresponds to X in Formula (1-2) in producing the Compound (1-2); and
the same applies to the reaction formulas below.

An example of synthesis of the Compound (1) will be described below.

[Chem. 13]

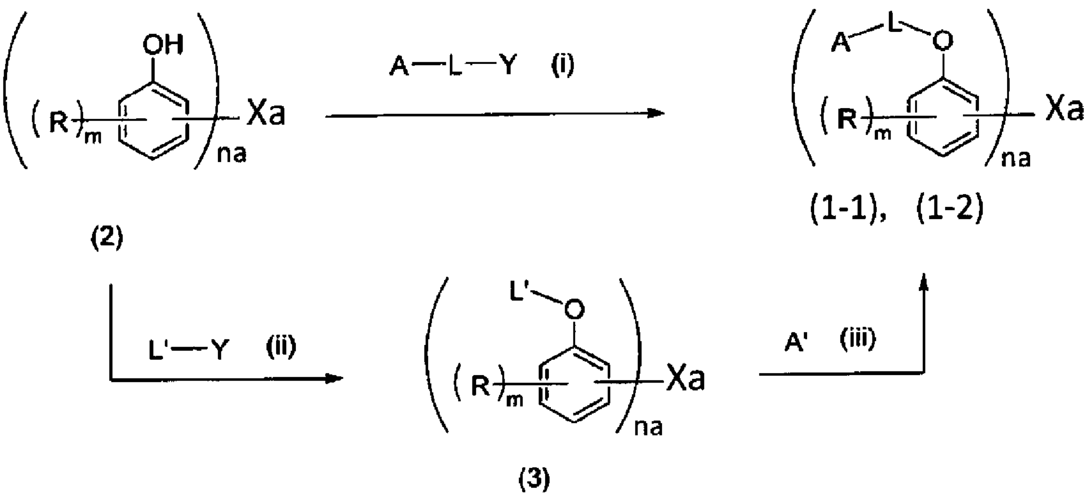


where in the above reaction formula, L corresponds to $L^1$ in Formula (1-1) above and $L^2$ in Formula (1-2) above; A corresponds to $A^1$ in Formula (1-1) above and $A^2$ in Formula (1-2) above;
Y represents a leaving group, such as a halogen atom, a sulfonic acid group (such as a methanesulfonic acid group, a tosyl acid group, or a trifluoromethanesulfonic acid group), a carboxyl group, a dimethylpyrazolyl group, or a 1-methylpropylideneaminooxy group; L' and A' represent precursor structures that become L and A, respectively, by causing a chemical reaction; and the same symbols represent the same entities also in the reaction formulas below.

For example, the Compound (1) is a compound (1A) in which the photopolymerizable group $A^1$ or $A^2$ is a (meth) acryloyl group in Formula (1-1) or (1-2). The Compound (1A) can be produced by a method of reacting a hydroxy group of the Compound (2) with a (meth)acrylating reagent having a polymerizable group represented by Formula (i) (which may hereinafter be referred to as the (meth)acrylating reagent (i)).
Examples of the (meth)acrylating reagent (i) include alkylating reagents, such as 2-methanesulfonylethyl (meth) acrylate, glycidyl (meth)acrylate, and 2,3-dibromopropyl acrylate.
Examples of the (meth)acrylating reagent (i) include isocyanates, such as 2-acryloyloxyethyl isocyanate, 2-methacryloyloxyethyl isocyanate, 2-(2-methacryloyloxyethyloxy)ethyl isocyanate, and 1,1-(bisacryloyloxymethyl)ethyl isocyanate; and carbonylaing reagents, such as 2-[(3,5-dimethylpyrazolyl)carbonylamino]ethyl methacrylate and 2-[O-(1'-methylpropylideneamino)carboxyamino]ethyl methacrylate.
Furthermore, the Compound (1A) can also be produced by a polymerizable group-forming reaction of a compound represented by Formula (3) (which may hereinafter be referred to as "Compound (3)") obtained by a reaction of the Compound (2) with a compound having a linking group represented by Formula (ii) with a (meth)acryloylating

reagent represented by Formula (iii).

To the reaction of the active hydrogen of the hydroxy group in Formula (2) with the reagent represented by (i) or (ii) above, and the reaction of the Compound (3) with the reagent represented by Formula (iii), a known technique can be applied. For example, the Compound (1A) is obtained by reacting the Compound (2) with an isocyanate in the presence of a basic compound.

The basic compound may be one or more of organic basic compounds (such as triethylamine, diisopropylethylamine, 1,1,3,3-tetramethylguanidine, diazabicycloundecene, diazabicyclononene, pyridine, and imidazole), one or more of inorganic basic compounds (such as sodium carbonate, potassium carbonate, sodium hydride, potassium hydride, and potassium tert-butoxide), or a combination of one or more of organic basic compounds and one or more of inorganic basic compounds.

In the reaction of the Compound (2) with the reagent represented by (i) or (ii) and the reaction of the Compound (3) with the reagent represented by Formula (iii), an organic solvent is preferably used. Examples of the organic solvent include dichloromethane, tetrahydrofuran (THF), dimethoxyethane, toluene, and N,N-dimethylformamide (DMF). One solvent may be used, or two or more solvents may be used in combination.

In the production of the Compound (1A), a reaction product (crude product) obtained by the synthesis reaction is preferably purified. Low colorability can be achieved by purification to remove impurities. As a purification method, a known technique can be applied. For example, the reaction product can be purified by an extraction method, column chromatography, a recrystallization method, a distillation method, and/or the like. Only one of these purification methods may be carried out, or these purification methods may be carried out sequentially in combination.

When the Compound (1A) is solid at ordinary temperature, a recrystallization method is preferably used in terms of easily and thoroughly removing a coloring substance.

Examples of the recrystallization solvent include aliphatic hydrocarbon-based solvents, such as n-pentane, n-hexane, and n-heptane; alicyclic hydrocarbon-based solvents, such as cyclopentane and cyclohexane; aromatic hydrocarbon-based solvents, such as toluene, ethylbenzene, xylene, and mesitylene; halogenated hydrocarbon-based solvents, such as methylene chloride, chloroform, and 1,2-dichloroethane; ether-based solvents, such as diethyl ether, diisopropyl ether, tetrahydrofuran, t-butyl methyl ether, and 1,4-dioxane; ketone-based solvents, such as acetone, methyl ethyl ketone, and methyl isobutyl ketone; ester-based solvents, such as ethyl acetate, n-butyl acetate, and propylene glycol monomethyl ether acetate; nitrile-based solvents, such as acetonitrile and propionitrile; alcohol-based solvents, such as methanol, ethanol, n-propanol, isopropanol, n-butanol, 2-butanol, t-butanol, 2-methoxyethanol, 2-butoxyethanol, and propylene glycol monomethyl ether; glycol-based solvents, such as ethylene glycol and diethylene glycol; and water. One of these solvents may be used alone, or two or more may be used in combination.

The Compound (2) used as a raw material compound and the intermediate compound (3) used in the production of the Compound (1A) can be produced by the following reaction.

[Chem. 14]

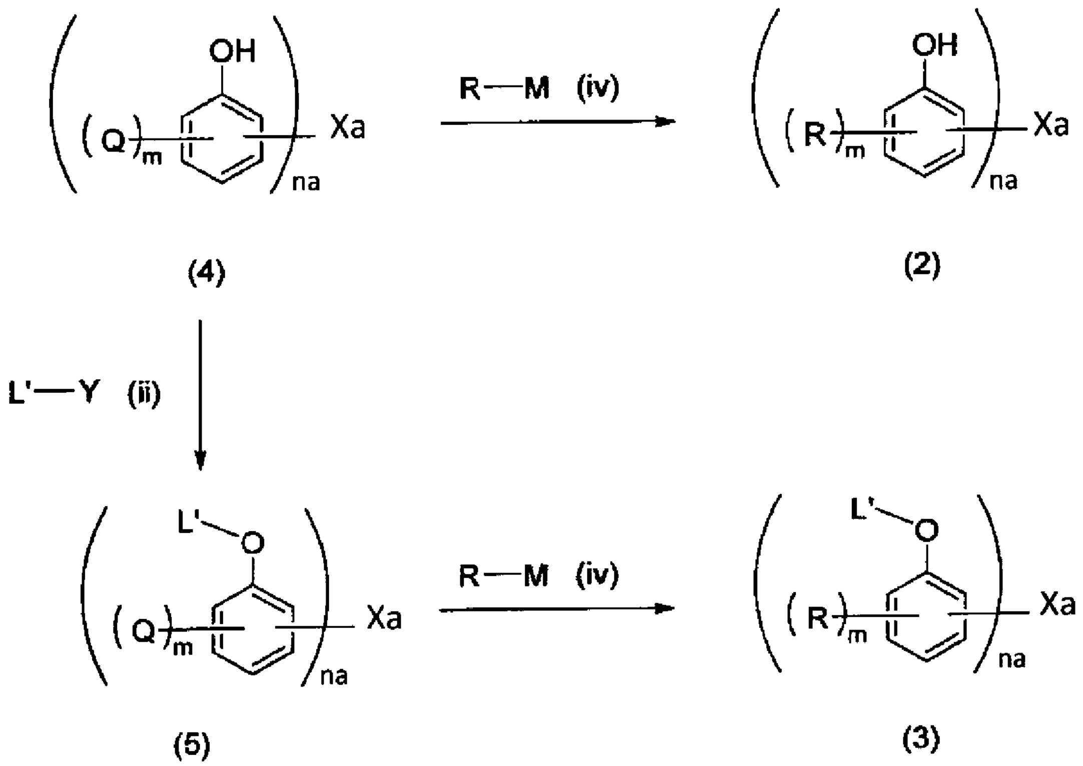


(4) (2) (5) (3)

where in the above reaction formula, Q represents a leaving group, such as a halogen atom or a trifluoromethanesulfonic acid group; and R-M represents an organometallic reagent capable of forming a carbon-carbon bond by reacting with Q, such as an organolithium reagent, an organomagnesium reagent, an organozinc reagent, an organocerium reagent, an organosilicon reagent, an organoboron reagent, or an organotin reagent, or an aromatic ring compound directly using a carbon-hydrogen bond to cause a cross-coupling reaction.

For example, the Compound (2) can be synthesized by simultaneously or sequentially linking a plurality of fused aromatic ring groups R by a linking reaction between an aromatic halide represented by Formula (4) (which may hereinafter be referred to as "Compound (4)") and an organic reagent represented by Formula (iv).

In addition, the Compound (3) can be synthesized by simultaneously or sequentially linking a plurality of fused aromatic ring groups R by a linking reaction with an organic reagent represented by Formula (iv) to a compound represented by Formula (5) (which may hereinafter be referred to as "Compound (5)") obtained by a reaction of the Compound (4) with a compound having a linking group represented by Formula (ii).

2. Photosensitive Composition for Hologram Recording of Present Invention

The photosensitive composition for hologram recording of the present invention contains a photopolymerization initiator. The photopolymerization initiator allows the photopolymerizable groups $A^1$ or $A^2$ of the Compound (1) to polymerize, and a polymer of the present invention can be obtained.

The composition of the present invention may contain a photopolymerizable monomer other than the Compound (1).

The composition of the present invention, which is a photosensitive composition for hologram recording, is preferably a photo composition containing a matrix resin, a radical scavenger, and an additional additive in addition to the photopolymerizable monomer and the photopolymerization initiator. Hereinafter, details of the composition of the present invention used as a material for a hologram recording medium will be described.

2-1. Photopolymerization Initiator

As the photopolymerization initiator contained in the composition of the present invention, a photoradical polymerization initiator, a photocationic polymerization initiator, or the like can be used.

Examples of the photopolymerization initiator described later also include those commonly referred to as polymerization catalysts.

The content of the photopolymerization initiator in the composition of the present invention is preferably 0.5 μmol/g or more in terms of the molar amount per unit weight of the composition. The content is more preferably 1 μmol/g or more. The content of the photopolymerization initiator in the composition of the present invention is preferably 100 μmol/g or less in terms of the molar amount per unit weight of the composition. The content is more preferably 50 μmol/g or less.
Too low a content of the photopolymerization initiator would reduce the amount of generated radicals. This would reduce the speed of photopolymerization and may result in lower recording sensitivity in a hologram recording medium. Too high a content of the photopolymerization initiator would cause radicals generated by light irradiation to recombine with each other and disproportionate. This would reduce the contribution to photopolymerization and may also result in lower recording sensitivity in a hologram recording medium. When two or more photopolymerization initiators are used in combination, their total amount is preferably adjusted to satisfy the above range.

2-1-1. Photoradical Polymerization Initiator

As the photoradical polymerization initiator for assisting the polymerization of the composition of the present invention, any known photoradical polymerization initiator can be used. Examples of the photoradical polymerization initiator used in the composition include azo compounds, azide compounds, organic peroxides, organoborate salts, bisimidazole derivatives, titanocene compounds, iodonium salts, organic thiol compounds, halogenated hydrocarbon derivatives, acetophenones, benzophenones, hydroxybenzenes, thioxanthones, anthraquinones, ketals, acylphosphine oxides, sulfone compounds, carbamic acid derivatives, sulfonamides, triarylmethanols, and oxime esters. Among these, the photoradical polymerization initiator is preferably a titanocene compound, an acylphosphine oxide compound, an oxime ester compound, or the like, because a polymerization reaction occurs by light in the visible region. From the viewpoints of compatibility and ease of availability, the photoradical polymerization initiator is preferably a benzophenone, an acylphosphine oxide compound, an oxime ester compound, or the like.
When a titanocene compound is used as the photoradical polymerization initiator, its type is not particularly limited. For example, the titanocene compound can be used by appropriately selecting from various titanocene compounds described in JP S59-152396 A and JP S61-151197 A.
Specific examples of the titanocene compound include dicyclopentadienyl-Ti-dichloride, dicyclopentadienyl-Ti-bis(phenyl), dicyclopentadienyl-Ti-bis(2,3,4,5,6-pentafluorophen-1-yl), dicyclopentadienyl-Ti-bis(2,3,5,6-tetrafluorophen-1-yl), dicyclopentadienyl-Ti-bis(2,4,6-trifluorophen-1-yl), dicyclopentadienyl-Ti-bis(2,6-difluorophen-1-yl), dicyclopentadienyl-Ti-bis(2,4-di-fluorophen-1-yl), dimethylcyclopentadienyl-Ti-bis(2,3,4,5,6-pentafluorophen-1-yl), dimethylcyclopentadienyl-Ti-bis(2,3,5,6-tetrafluorophen-1-yl), dimethylcyclopentadienyl-Ti-bis(2,6-difluorophen-1-yl), and dicyclopentadienyl-Ti-bis(2,6-difluoro-3-(pyr-1-yl)-phen-1-yl).
Specific examples of the acylphosphine oxide compound include a monofunctional initiator having only one photocleavable site per molecule and a bifunctional initiator having two photocleavable sites per molecule.
Specific examples of the monofunctional initiator include triphenylphosphine oxide, diphenyl(2,4,6-trimethylbenzoyl)phosphine oxide, and 2,6-dichlorobenzoyldiphenylphosphine oxide.
Examples of the bifunctional initiator include bis(2,4,6-trimethylbenzoyl)-phenylphosphine oxide, bis(2,6-dimethoxybenzoyl)-2,4,4-trimethylpentylphosphine oxide, bis(2,6-dichlorobenzoyl)-4-propylphenylphosphine oxide, and bis(2,6-dichlorobenzoyl)-2,5-dimethylphenylphosphine oxide.
Specific examples of the oxime ester compound include 1-[4-(phenylthio)-2-(O-benzoyloxime)]-1,2-octanedione, 1-[9-ethyl-6-(2-methylbenzoyl)-9H-carbazol-3-yl]-1-(O-acetyloxime)ethanone, methyl 4-(acetoxyimino)-5-[9-ethyl-6-(2-methylbenzoyl)-9H-carbazol-3-yl]-5-oxopentanoate, methyl 1-(9-ethyl-6-cyclohexanoyl-9H-carbazol-3-yl)-1-(O-acetyloxime)glutarate, methyl 1-(9-ethyl-9H-carbazol-3-yl)-1-(O-acetyloxime)glutarate, and 1-(9-ethyl-9H-carbazol-3-yl)-1-(O-acetyloxime)-3-methylbutanoic acid.
Specific examples of a preferred photoradical polymerization initiator include benzophenone, 2,4,6-trimethylbenzophenone, methyl ortho-benzoylbenzoate, 4-phenylbenzophenone, t-butylanthraquinone, 2-ethyl anthraquinone, diethoxyacetophenone, 2-hydroxy-2-methyl-1-phenylpropan-1-one, oligo{2-hydroxy-2-methyl-1-[4-(1-methylethenyl) phenyl]propanone}, benzyldimethylketal, 1-hydroxycyclohexyl phenyl ketone, benzoin methyl ether, benzoin ethyl ether, benzoin isopropyl ether, benzoin isobutyl ether, 2-methyl-[4-(methylthio)phenyl]-2-morpholino-1-propanone, 2-benzyl-2-dimethylamino-1-(4-morpholinophenyl)-1-butanone-1, diethylthioxanthone, isopropylthioxanthone, 2,4,6-trimethylbenzoyldiphenylphosphine oxide, bis(2,6-dimethoxybenzoyl)-2,4,4-trimethylpentylphosphine oxide, bis(2,4,6-trimethylbenzoyl)-phenylphosphine oxide, 2-hydroxy-1-{4-[4-(2-hydroxy-2-methylpropionyl)benzyl]phenyl}-2-methylpropan-1-one, methyl benzoylformate, 1-[4-(phenylthio)-2-(O-benzoyloxime)]-1,2-octanedione, and 1-[9-ethyl-6-(2-methylbenzoyl)-9H-carbazol-3-yl]-1-(O-acetyloxime)ethanone.
Any one of these photoradical polymerization initiators may be used alone, or two or more may be used in any combination and ratio.

2-1-2. Photocationic Polymerization Initiator

The photocationic polymerization initiator in the present invention refers to an initiator that generates a cationic species by light. The photocationic polymerization initiator is not particularly limited as long as it is a compound that generates a cationic species by light irradiation, but onium salts are generally well known.

Examples of the onium salt include a diazonium salt of a Lewis acid, an iodonium salt of a Lewis acid, and a sulfonium salt of a Lewis acid. Specific examples include a phenyldiazonium salt of boron tetrafluoride, a diphenyliodonium salt of phosphorus hexafluoride, a diphenyliodonium salt of antimony hexafluoride, a tri(4-methylphenyl)sulfonium salt of arsenic hexafluoride, and a tri(4-methylphenyl)sulfonium salt of antimony tetrafluoride. An aromatic sulfonium salt is preferably used.

Specific examples of the photocationic polymerization initiator include S,S,S',S'-tetraphenyl-S,S'-(4,4'-thiodiphenyl)disulfonium bis(hexafluorophosphate), diphenyl-4-phenylthiophenylsulfonium hexafluorophosphate, and diphenyl-4-phenylthiophenylsulfonium hexafluoroantimonate. Examples include UVI-6992 (trade name) available from Dow Chemical, CPI-100P (trade name) available from San-Apro Ltd., CPI-101A (trade name) available from San-Apro Ltd., CPI-200K (trade name) available from San-Apro Ltd., and Omnicat 270 (trade name) available from IGM Resins.

Any one of these photocationic polymerization initiators may be used alone, or two or more may be used in any combination and ratio.

The amount of the photocationic polymerization initiator in the composition of the present invention is preferably 0.02 parts by mass or more and 20 parts by mass or less, and more preferably 0.1 parts by mass or more and 10 parts by mass or less per 100 parts by mass of the total of all photocationic polymerizable compounds in the composition. The photocationic polymerization initiator in an amount less than 0.02 parts by mass would not allow sufficient reaction to occur. Blending the photocationic polymerization initiator in an amount exceeding 20 parts by mass would make it difficult to achieve both the pot life and the polymerization rate.

In the use of the photocationic polymerization initiator, a photocationic polymerization sensitizer may be used in combination. The photocationic polymerization sensitizer is a formulation that efficiently transfers the energy of irradiation light to the photocationic polymerization initiator by using the photocationic polymerization sensitizer in combination when the irradiation light of a light source used for photocationic polymerization does not sufficiently match the absorption wavelength of the photocationic polymerization initiator. Examples of known photocationic polymerization sensitizers include a phenolic compound, such as methoxyphenol, as described in JP H05-230189 A; a thioxanthone compound (JP 2000-204284 A); and a dialkoxyanthracene compound (JP 2000-119306 A).

The photocationic polymerization sensitizer is typically used in a range of 0.2 to 5 parts by mass and preferably in a range of 0.5 to 1 part by mass per part by mass of the photocationic polymerization initiator. Too small an amount of the photocationic polymerization sensitizer would make it difficult to exhibit the sensitizing effect. Too large an amount of the photocationic polymerization sensitizer may deteriorate the physical properties of the polymer.

2-2. About Additional Photopolymerizable Monomer Other Than Compound (1)

The composition of the present invention may contain an additional photopolymerizable monomer other than the Compound (1) (such a photopolymerizable monomer may hereinafter be referred to as a "concomitant monomer").

Examples of the concomitant monomer other than the Compound (1) include photocationic polymerizable monomers and photoradical polymerizable monomers. Any one of these concomitant monomers may be used alone, or two or more may be used in any combination and ratio.

When only a monofunctional photopolymerizable monomer is used as the Compound (1), a polyfunctional photopolymerizable monomer other than the Compound (1) is contained as the concomitant monomer. The polyfunctional photopolymerizable monomer used in combination is preferably a tri- or higher functional monomer in that the archivability of the hologram can be greatly improved. On the other hand, from the viewpoint of suppressing the curing shrinkage of the recording material, a bifunctional monomer is preferably used in combination.

When only a polyfunctional photopolymerizable monomer is used as the Compound (1), the composition of the present invention contains a monofunctional photopolymerizable monomer as the concomitant monomer because the forming processability can be improved.

When a monofunctional photopolymerizable monomer and a polyfunctional photopolymerizable monomer are used as the Compound (1), the concomitant monomer may be either a monofunctional photopolymerizable monomer or a polyfunctional photopolymerizable monomer.

When the composition of the present invention contains a concomitant monomer other than the Compound (1), the content is preferably 0.1 mass% or more and 90 mass% or less and particularly preferably 0.3 mass% or more and 80 mass% or less in terms of the ratio to the total solid content of the composition of the present invention. The content proportion of the concomitant monomer less than 0.1 mass% would fail to exhibit sufficient effect of imparting characteristics by its addition. The content of the concomitant monomer exceeding 90 mass% would likely cause problems, such as

impairment of the effect of the Compound (1), including the effect of suppressing the fluorescence phenomenon.

The content of the photopolymerizable monomer in the composition of the present invention may be freely determined as long as it is not against the gist of the present invention. However, the content of all photopolymerizable monomers including the Compound (1) is preferably 5 μmol/g or more, more preferably 10 μmol/g or more, and even more preferably 100 μmol/g or more, based on the molar amount per unit mass of the composition. The content of all photopolymerizable monomers is preferably 1000 μmol/g or less, more preferably 800 μmol/g or less, and even more preferably 500 μmol/g or less.

The content of the photopolymerizable monomer not less than the above lower limit value provides sufficient diffraction efficiency in a hologram recording medium. The content of the copolymerizable monomer not more than the above upper limit value tends to maintain compatibility with a resin matrix in a recording layer, tending to maintain low shrinkage of the recording layer due to recording.

Photocationic Polymerizable Monomer

Examples of the photocationic polymerizable concomitant monomer include compounds having an oxirane ring, styrene and its derivatives, vinylnaphthalene and its derivatives, vinyl ethers, N-vinyl compounds, and compounds having an oxetane ring.

Among these, it is preferred to use at least a compound having an oxetane ring, and furthermore, it is preferred to use a compound having an oxirane ring in combination with a compound having an oxetane ring.

Examples of the compound having an oxirane ring include a prepolymer containing two or more oxirane rings per molecule.

Examples of such a prepolymer include alicyclic polyepoxies, polyglycidyl esters of a polybasic acid, polyglycidyl ethers of a polyhydric alcohol, polyglycidyl ethers of a polyoxyalkylene glycol, polyglycidyl ethers of an aromatic polyol, hydrogenated compounds of polyglycidyl ethers of an aromatic polyol, urethane polyepoxy compounds, and epoxidized polybutadienes.

Examples of styrene and its derivative include styrene, p-methylstyrene, p-methoxystyrene, β-methylstyrene, p-methyl-β-methylstyrene, α-methylstyrene, p-methoxy-β-methylstyrene, and divinylbenzene.

Examples of vinylnaphthalene and its derivative include 1-vinylnaphthalene, α-methyl-1-vinylnaphthalene, β-methyl-1-vinylnaphthalene, 4-methyl-1-vinylnaphthalene, and 4-methoxy-1-vinylnaphthalene.

Examples of the vinyl ether include isobutyl ether, ethyl vinyl ether, phenyl vinyl ether, p-methylphenyl vinyl ether, and p-methoxyphenyl vinyl ether.

Examples of the N-vinyl compound include N-vinylcarbazole, N-vinylpyrrolidone, N-vinylindole, N-vinylpyrrole, and N-vinylphenothiazine.

Examples of the compound having an oxetane ring include various known oxetane compounds described in JP 2001-220526 A, JP 2001-310937 A, and the like.

Any one of these photocationic polymerizable concomitant monomers may be used alone, or two or more may be used in any combination and ratio.

Photoradical Polymerizable Monomer

The photoradical polymerizable concomitant monomer is a compound having one or more ethylenically unsaturated double bonds per molecule, and examples include (meth)acrylic esters, (meth)acrylamides, vinyl esters, and styrenes.

Examples of the (meth)acrylic ester include methyl (meth)acrylate, ethyl (meth)acrylate, (n- or i-)propyl (meth) acrylate, (n-, i-, sec-, or t-)butyl (meth)acrylate, amyl (meth)acrylate, adamantyl (meth)acrylate, chloroethyl (meth) acrylate, 2-hydroxyethyl (meth)acrylate, 2-hydroxypropyl (meth)acrylate, 2-hydroxypentyl (meth)acrylate, cyclohexyl (meth)acrylate, allyl (meth)acrylate, trimethylolpropane mono(meth)acrylate, pentaerythritol mono(meth)acrylate, benzyl (meth)acrylate, methoxybenzyl (meth)acrylate, chlorobenzyl (meth)acrylate, hydroxybenzyl (meth)acrylate, hydroxyphenethyl (meth)acrylate, dihydroxyphenethyl (meth)acrylate, furfuryl (meth)acrylate, tetrahydrofurfuryl (meth)acrylate, phenyl (meth)acrylate, hydroxyphenyl (meth)acrylate, chlorophenyl (meth)acrylate, sulfamoylphenyl (meth)acrylate, 2-phenoxyethyl (meth)acrylate, 2-(hydroxyphenylcarbonyloxy)ethyl (meth)acrylate, phenol EO-modified (meth)acrylate, phenylphenol EO-modified (meth)acrylate, paracumylphenol EO-modified (meth)acrylate, nonylphenol EO-modified (meth)acrylate, N-acryloyloxyethylhexahydrophthalimide, bisphenol F EO-modified diacrylate, bisphenol A EO-modified diacrylate, dibromophenyl (meth)acrylate, tribromophenyl (meth)acrylate, dicyclopentenyloxyethyl (meth)acrylate, dicyclopentanyl acrylate, tricyclodecanedimethylol di(meth)acrylate, bis(phenoxyethanol fluorene) di(meth)acrylate, trimethylolpropane tri(meth)acrylate, pentaerythritol tri(meth)acrylate, pentaerythritol tetra(meth)acrylate, dipentaerythritol penta(meth)acrylate, and dipentaerythritol hexa(meth)acrylate. Here, "EO" means "ethylene oxide".

Examples of the (meth)acrylamide include (meth)acrylamide, N-methyl (meth)acrylamide, N-ethyl (meth)acrylamide, N-propyl (meth)acrylamide, N-butyl (meth)acrylamide, N-benzyl (meth)acrylamide, N-hydroxyethyl (meth) acrylamide, N-phenyl (meth)acrylamide, N-tolyl (meth)acrylamide, N-(hydroxyphenyl) (meth)acrylamide, N-(sulfamoylphenyl) (meth)acrylamide, N-(phenylsulfonyl) (meth)acrylamide, N-(tolylsulfonyl) (meth)acrylamide, N,N-dimethyl (meth) acrylamide, N-methyl-N-phenyl (meth)acrylamide, and N-hydroxyethyl-N-methyl (meth)acrylamide.

Examples of the vinyl ester include vinyl acetate, vinyl butyrate, vinyl benzoate, vinyl benzoate, vinyl t-butylbenzoate, vinyl chlorobenzoate, vinyl 4-ethoxybenzoate, vinyl 4-ethylbenzoate, vinyl 4-methylbenzoate, vinyl 3-methylbenzoate, vinyl 2-methylbenzoate, vinyl 4-phenylbenzoate, and vinyl pivalate.

Examples of the styrene include styrene, p-acetylstyrene, p-benzoylstyrene, 2-butoxymethylstyrene, 4-butylstyrene, 4-sec-butylstyrene, 4-tert-butylstyrene, 2-chlorostyrene, 3-chlorostyrene, 4-chlorostyrene, dichlorostyrene, 2,4-diisopropylstyrene, dimethylstyrene, p-ethoxystyrene, 2-ethylstyrene, 2-methoxystyrene, 4-methoxystyrene, 2-methylstyrene, 3-methylstyrene, 4-methylstyrene, p-methylstyrene, p-phenoxystyrene, p-phenylstyrene, and divinylbenzene.

Any one of these photoradical polymerizable concomitant monomers may be used alone, or two or more may be used in any combination and ratio.

Any of the photocationic polymerizable concomitant monomers and the photo-radical polymerizable concomitant monomers exemplified above can be used, and two or more may be used in combination.

The photoradical polymerizable concomitant monomer is less likely to inhibit a reaction for forming a resin matrix and thus is preferably used as the additional photopolymerizable monomer used in combination with the Compound (1), for example, for high-refractive-index optical lenses or hologram recording media.

2-3. Solvent

The composition of the present invention may contain a solvent to adjust the viscosity.

Specific examples of the solvent include organic solvents according to the physical properties of the composition, for example, alcohols, such as ethanol, propanol, isopropanol, ethylene glycol, and propylene glycol; aliphatic hydrocarbons, such as hexane, pentane, and heptane; alicyclic hydrocarbons, such as cyclopentane and cyclohexane; aromatic hydrocarbons, such as toluene and xylene; halogenated hydrocarbons, such as methylene chloride and chloroform; chain ethers, such as dimethyl ether and diethyl ether; cyclic ethers, such as dioxane and tetrahydrofuran; esters, such as methyl acetate, ethyl acetate, butyl acetate, ethyl lactate, and ethyl butyrate; ketones, such as acetone, ethyl methyl ketone, methyl isobutyl ketone, and cyclohexanone; cellosolves, such as methyl cellosolve, ethyl cellosolve, and butyl cellosolve; carbitols, such as methyl carbitol, ethyl carbitol, and butyl carbitol; propylene glycol monoalkyl ethers, such as propylene glycol monomethyl ether, propylene glycol monoethyl ether, and propylene glycol mono-n-butyl ether; glycol ether esters, such as ethylene glycol monomethyl ether acetate and propylene glycol monomethyl ether acetate; N,N-dimethylformamide, N,N-dimethylacetamide, and the like); sulfoxides (amides, such as dimethyl sulfoxide; nitriles, such as acetonitrile and benzonitrile; and N-methylpyrrolidone.

These solvents can be used alone or as a mixed solvent. In addition, water can be used according to the polymerization method (such as emulsion polymerization or suspension polymerization).

When a solvent (or dispersion medium) is used, its amount is not particularly limited and is used by adjusting so as to obtain a composition with a suitable viscosity according to the polymerization method, the processing method, and the application.

2-4. Matrix Resin

The composition of the present invention preferably contains a matrix resin. In particular, a matrix resin constituting a recording layer of a hologram recording medium is an organic material that does not undergo a significant chemical or physical change by irradiation with light, and is mainly composed of a polymer of an organic compound.

The matrix resin constitutes the composition of the present invention together with the polymerizable compound described above, the photopolymerization initiator described later, and the like, and thus is strongly required to have excellent compatibility with the polymerizable compound, the photopolymerization initiator, and the like. Low compatibility between the matrix resin and the other components would lead to the formation of interfaces between the materials, and light would be refracted and/or reflected at the interfaces, thereby causing leakage of light to unnecessary portions. This would distort and/or cut interference fringes and cause recording in inappropriate portions, which may deteriorate the information. The compatibility between the matrix resin and the other components can be evaluated, for example, based on scattered light intensity obtained by placing a detector in a direction different from the direction of transmitted light with respect to a sample as described in JP 3737306 B.

The matrix resin that may be used in the composition of the present invention is a resin composed of a plurality of materials that are soluble in a solvent in the composition and then three-dimensionally crosslinked to form the resin after being formed into a state of use. Examples include thermoplastic resins, thermosetting resins, and photocurable resins described below.

The three-dimensionally crosslinked resin is insoluble in a solvent and is a reaction-cured product of a polymerizable compound that is liquid at ordinary temperature and a compound that is reactive with the polymerizable compound. The three-dimensionally crosslinked resin serves as a physical constraint and thus suppresses volume change during recording. That is, in the recording layer after recording, a bright part expands and a dark part contracts. This may tend to form unevenness on the surface of a hologram recording medium. To suppress this volume change, a composition containing a three-dimensionally crosslinked resin matrix is more preferably used in the recording layer.
Among these, the matrix resin is preferably a thermosetting resin in terms of adherence to a support. Hereinafter, resin materials that can be used as the matrix resin will be described in detail.

2-4-1. Thermoplastic Resin

Specific examples of the thermoplastic resin include chlorinated polyethylene; poly(methyl methacrylate) (PMMA) resins; copolymers of methyl methacrylate and another alkyl acrylate; copolymers of vinyl chloride and acrylonitrile; poly(vinyl acetate) (PVAC) resins; poly(vinyl alcohol); poly(vinyl formal); poly(vinylpyrrolidone); cellulose resins, such as ethyl cellulose and nitrocellulose; polystyrene resins; and polycarbonate resins. One of these may be used alone, or two or more may be used in combination.
The solvent for these thermoplastic resins is not particularly limited as long as it dissolves these resins. Examples of the solvent include ketones, such as acetone and methyl ethyl ketone; esters, such as butyl acetate and propylene glycol methyl ether acetate; aromatic hydrocarbons, such as toluene and xylene; ethers, such as tetrahydrofuran and 1,2-dimethoxyethane; and amides, such as N,N-dimethylacetamide and N-methylpyrrolidone. Only one of these may be used, or two or more may be mixed and used.

2-4-2. Thermosetting Resin

When a thermosetting resin is used as the matrix resin, the curing temperature varies depending on the type of crosslinker and/or catalyst.
Typical examples of combinations of functional groups that cure at room temperature include an epoxy and an amine, an epoxy and a thiol, and an isocyanate and an amine. In addition, when a catalyst is used, typical combinations include an epoxy and phenol, an epoxy and an acid anhydride, and an isocyanate and a polyol.
Although the former is convenient due to its immediate reactivity upon mixing, it can be difficult to adjust in applications such as hologram recording media that involve forming, because there is little time available for handling.
The latter is suitable for curing processes that involve forming, such as those used for hologram recording media, because the curing temperature and time can be freely adjusted by appropriately selecting the type and amount of catalyst.
Various types of resin raw materials ranging from low- to high-molecular-weight compounds are commercially available. Thus, an appropriate material can be selected while compatibility with a polymerizable reactive compound and/or a photoinitiator, adherence to a substrate, and the like are maintained.
Hereinafter, each raw material will be described. Any one of the raw materials may be used alone, or two or more may be used in combination.

Epoxy

Examples of the epoxy include polyglycidyl ether compounds of a polyol, such as (poly)ethylene glycol, (poly)propylene glycol, (poly)tetramethylene glycol, trimethylolpropane, and glycerin; alicyclic epoxy compounds having a 4- to 7-membered aliphatic cyclic group, such as 3,4-epoxycyclohexylmethyl-3,4-epoxycyclohexanecarboxylate and 3,4-epoxy-1-methylcyclohexyl-3,4-epoxy-1-methylhexanecarboxylate; bisphenol A-type epoxy compounds; hydrogenated bisphenol A-type epoxy compounds; bisphenol F-type epoxy compounds; and phenol or cresol novolac-type epoxy compounds.
The epoxy preferably has two or more epoxy groups per molecule, but its type is not particularly limited. A small number of epoxy groups present per molecule may fail to provide hardness required as the matrix. The upper limit of the number of epoxy groups per molecule is not particularly limited but is typically 8 or less and particularly preferably 4 or less. If the number of epoxy groups per molecule is too large, it would take considerable time to consume the epoxy groups and may take too much time to form the matrix resin.

Amine

Examples of the amine include those containing a primary or secondary amino group. Examples of such an amine include aliphatic polyamines, such as ethylenediamine, diethylenetriamine, and its derivatives; alicyclic polyamines, such as isophoronediamine, menthanediamine, N-aminoethylpiperazine, and its derivatives; aromatic polyamines, such as m-xylylenediamine, diaminodiphenylmethane, and its derivatives; polyamides, such as condensation products of a dicarboxylic acid (such as a dimer acid) with a polyamine described above; and imidazole compounds, such as 2-methylimidazole and its derivatives; as well as other compounds, such as dicyandiamide and adipic acid dihydrazide.

Thiol

Examples of the thiol include thiol compounds including dithiols, such as 1,3-butanedithiol, 1,4-butanedithiol, 2,3-butanedithiol, 1,2-benzenedithiol, 1,3-benzenedithiol, 1,4-benzenedithiol, 1,10-decanedithiol, 1,2-ethanedithiol, 1,6-hexanedithiol, and 1,9-nonanedithiol; polythiols, such as Thiokol (available from Toray Fine Chemicals Co., Ltd.) and jER Cure QX40 (available from Mitsubishi Chemical Corporation). Among these, a commercially available fast-curing polythiol, such as jER Cure QX40, is suitably used.

Phenol

Examples of the phenol include bisphenol A, novolac-type phenol resins, and resol-type phenol resins.

Acid Anhydride

Examples of the acid anhydride include monofunctional acid anhydrides, such as phthalic anhydride, tetrahydrophthalic anhydride, and its derivatives; and bifunctional acid anhydrides, such as pyromellitic dianhydride, benzophenonetetracarboxylic dianhydride, and its derivatives.

Amounts of Amine, Thiol, Phenol, and Acid Anhydride to Be Used

The amount of the amine, thiol, phenol, or acid anhydride to be used is, in proportion to the number of moles of the epoxy group, preferably in a range of 0.1 equivalents or more, particularly 0.7 equivalents or more, typically 2.0 equivalents or less, and particularly 1.5 equivalents or less. Too small or too large an amount of the amine, thiol, phenol, or acid anhydride to be used would result in a large number of unreacted functional groups and may impair the storage stability.

Polymerization Initiator for Thermosetting Resin

As a catalyst for curing the thermosetting resin, an anionic polymerization initiator or a cationic polymerization initiator can be used according to the curing temperature and the curing time.

An anionic polymerization initiator generates an anion by heat or active energy ray irradiation. Examples include amines. Examples of the amine include amino group-containing compounds, such as dimethylbenzylamine, dimethylaminomethylphenol, 1,8-diazabicyclo[5.4.0]undecene-7, and their derivatives; and imidazole compounds, such as imidazole, 2-methylimidazole, 2-ethyl-4-methylimidazole, and their derivatives. One or more of these can be used according to the curing temperature and curing time.

A cationic polymerization initiator generates a cation by heat or active energy ray irradiation. Examples include aromatic onium salts. Specific examples include compounds composed of an anion component, such as $SbF_6^-$, $BF_4^-$, $AsF_6^-$, $PF_6^-$, $CF_3SO_3^-$, or $B(C_6F_5)_4^-$, and an aromatic cation component containing an atom, such as iodine, sulfur, nitrogen, or phosphorus. Among these, a diaryliodonium salt, a triarylsulfonium salt, or the like is preferred. One or more of these can be used according to the curing temperature and curing time.

The amount of any of these polymerization initiators for a thermosetting resin to be used is preferably in a range of typically 0.001 mass% or more, particularly 0.01 mass% or more, typically 50 mass% or less, and particularly 10 mass% or less relative to the matrix resin. An excessively small amount of any of these polymerization initiators for a thermosetting resin to be used would result in too low a concentration of the polymerization initiator for a thermosetting resin. Thus, the polymerization reaction may take too much time. On the other hand, an excessively large amount of the polymerization initiator for a thermosetting resin to be used may fail to allow a continuous ring-opening reaction as the polymerization reaction.

Isocyanate

The isocyanate is preferably one having two or more isocyanate groups per molecule, but its type is not particularly limited. A small number of isocyanate groups present per molecule may fail to provide hardness required as the matrix resin. The upper limit of the number of isocyanate groups per molecule is not particularly limited but is typically 8 or less and particularly preferably 4 or less. If the number of isocyanate groups per molecule is too large, it would take considerable time to consume the isocyanate groups and may take too much time to form the matrix resin. The upper limit

of the number of isocyanate groups per molecule is not particularly limited but is typically about 20 or less.

Examples of the isocyanate include aliphatic isocyanates, such as hexamethylene diisocyanate, lysine methyl ester diisocyanate, and 2,4,4-trimethylhexamethylene diisocyanate; alicyclic isocyanates, such as isophorone diisocyanate and 4,4'-methylenebis(cyclohexyl isocyanate); aromatic isocyanates, such as tolylene diisocyanate, 4,4'-diphenylmethane diisocyanate, xylylene diisocyanate, and naphthalene-1,5-diisocyanate; and their multimers. Among these, trimers to heptamers are preferred.

In addition to this, examples include reaction products of water or a polyhydric alcohol, such as trimethylolethane or trimethylolpropane, with any of the above isocyanates; and a multimer of hexamethylene diisocyanate, or its derivative.

The molecular weight of the isocyanate is preferably 100 or more and 50000 or less in terms of number-average molecular weight, more preferably 150 or more and 10000 or less, and even more preferably 150 or more and 5000 or less. An excessively low number-average molecular weight would increase the crosslink density, thereby excessively increasing the hardness of the matrix resin and possibly reducing the recording speed. An excessively high number-average molecular weight would reduce the compatibility with other components and/or reduce the crosslink density, thereby excessively reducing the hardness of the matrix resin, and may lead to loss of recorded content.

Polyol

Examples of the polyol include polypropylene polyol, polycaprolactone polyol, polyester polyol, and polycarbonate polyol.

Polypropylene Polyol

A polypropylene polyol is obtained by a reaction of propylene oxide with a diol or a polyhydric alcohol. Examples of the diol or polyhydric alcohol include ethylene glycol, propylene glycol, 1,4-butanediol, 1,5-pentanediol, 3-methyl-1,5-pentanediol, 1,6-hexanediol, neopentyl glycol, diethylene glycol, 1,4-cyclohexanediol, 1,4-cyclohexanedimethanol, decamethylene glycol, polyethylene glycol, and polytetramethylene glycol. Examples of commercially available polypropylene polyols include SANNIX GP-400 and GP-1000 (trade names, both available from Sanyo Chemical Industries, Ltd.) and ADEKA POLYETHER G400, G700, and G1500 (trade names, all available from ADEKA Corporation).

Polycaprolactone Polyol

A polycaprolactone polyol is obtained by a reaction of a lactone with a diol or a polyhydric alcohol. Examples of the lactone include α-caprolactone, β-caprolactone, γ-caprolactone, ε-caprolactone, α-methyl-ε-caprolactone, and β-methyl-ε-caprolactone.

Examples of the diol or polyhydric alcohol include ethylene glycol, propylene glycol, 1,4-butanediol, 1,5-pentanediol, 3-methyl-1,5-pentanediol, 1,6-hexanediol, neopentyl glycol, diethylene glycol, 1,4-cyclohexanediol, 1,4-cyclohexanedimethanol, decamethylene glycol, polyethylene glycol, and polytetramethylene glycol.

Examples of commercially available products of a polycaprolactone polyol obtained by a reaction of ε-caprolactone include PLACCEL 205, PLACCEL 205H, PLACCEL 205U, PLACCEL 205UT, PLACCEL 210, PLACCEL 210N, PLACCEL 210CP, PLACCEL 220, PLACCEL 230, PLACCEL 230N, PLACCEL 240, PLACCEL 220EB, PLACCEL 220EC, PLACCEL 303, PLACCEL 305, PLACCEL 308, PLACCEL 309, PLACCEL 312, PLACCEL 320, PLACCEL 401, PLACCEL L205AL, PLACCEL L212AL, PLACCEL L220AL, PLACCEL L320AL, PLACCEL T2103, PLACCEL T2205, PLACCEL P3403, and PLACCEL 410 (trade names, all available from Daicel Corporation).

Polyester Polyol

Examples of the polyester polyol include those obtained by polycondensation of dicarboxylic acids or their anhydrides with polyols.

Examples of the dicarboxylic acid include succinic acid, adipic acid, sebacic acid, azelaic acid, dimer acids, maleic anhydride, isophthalic acid, terephthalic acid, and trimellitic acid.

Examples of the polyol include ethylene glycol, propylene glycol, 1,4-butanediol, 1,5-pentanediol, 3-methyl-1,5-pentanediol, 1,6-hexanediol, neopentyl glycol, diethylene glycol, 1,4-cyclohexanediol, 1,4-cyclohexanedimethanol, decamethylene glycol, polyethylene glycol, and polytetramethylene glycol.

Examples of the polyester polyol include polyethylene adipate, polybutylene adipate, and polyhexamethylene adipate. Examples of commercially available polyester polyols include ADEKA NEWACE F series, ADEKA NEWACE Y series, and ADEKA NEWACE NS series (trade names, all available from ADEKA Corporation); and Kuraray Polyol N-2010, P-4011, and P-1020 (trade names, all available from Kuraray Co., Ltd.).

Polycarbonate Polyol

Examples of the polycarbonate polyol include those obtained by a dealcoholization condensation reaction of a glycol with a dialkyl carbonate (e.g., dimethyl carbonate or diethyl carbonate), those obtained by a dephenolization condensation reaction of a glycol with a diphenyl carbonate, and those obtained by a deglycolization condensation reaction of a glycol with a carbonate (e.g., ethylene carbonate or diethyl carbonate).

Examples of the glycol include aliphatic diols, such as 1,6-hexanediol, diethylene glycol, propylene glycol, 1,4-butanediol, 3-methyl-1,5-pentanediol, and neopentyl glycol; and alicyclic diols, such as 1,4-cyclohexanediol and 1,4-cyclohexanedimethanol.

Examples of the polycarbonate polyol include poly(hexamethylene carbonate) polyol obtained by a condensation reaction of 1,6-hexanediol with diethyl carbonate, poly(pentylene carbonate) obtained by a condensation reaction of pentanediol with diethyl carbonate, and poly(butylene carbonate) obtained by a condensation reaction of 1,4-butanediol with diethyl carbonate.

Examples of commercially available products of a polycarbonate polyol include PLACCEL CD CD205, PLACCEL CD CD210, and PLACCEL CD CD220 (trade names, all available from Daicel Corporation); and DURANOL T5651, DURANOL T5652, and DURANOL T5650J (trade names, all available from Asahi Kasei Corporation).

Molecular Weight of Polyol

The molecular weight of the polyol described above is preferably 100 or more and 50000 or less, more preferably 150 or more and 10000 or less, and even more preferably 150 or more and 5000 or less, in terms of number-average molecular weight. An excessively low number-average molecular weight would increase the crosslink density, thereby excessively increasing the hardness of the matrix resin and possibly reducing the recording speed. An excessively high number-average molecular weight would reduce the compatibility with other components and/or reduce the crosslink density, thereby excessively reducing the hardness of the matrix resin, and may lead to loss of recorded content.

Additional Component

The matrix resin in the present embodiment may contain an additional component in addition to the components described above as long as it is not inconsistent with the gist of the present invention.

Examples of such an additional component include compounds having a hydroxyl group used, for example, to modify the physical properties of the matrix resin. Such a compound includes ethylene glycol, propylene glycol, 1,4-butanediol, 1,5-pentanediol, 3-methyl-1,5-pentanediol, 1,6-hexanediol, neopentyl glycol, diethylene glycol, 1,4-cyclohexanediol, 1,4-cyclohexanedimethanol, decamethylene glycol, trimethylolpropane, polyethylene glycol, and polytetramethylene glycol.

Urethane Polymerization Catalyst

The matrix resin may contain a suitable urethane polymerization catalyst to promote a reaction of an isocyanate with a polyol.

Examples of the urethane polymerization catalyst include onium salts, such as bis(4-t-butylphenyl)iodonium perfluoro-1-butanesulfonate, bis(4-t-butylphenyl)iodonium p-toluene-sulfonate, bis(4-t-butylphenyl)iodonium trifluoromethanesulfonate, (4-bromophenyl)diphenylsulfonium triflate, (4-t-butylphenyl)diphenylsulfonium trifluoromethanesulfonate, diphenyliodonium perfluoro-1-butanesulfonate, (4-fluorophenyl)diphenylsulfonium trifluoromethanesulfonate, diphenyl-4-methylphenylsulfonium trifluoromethanesulfonate, triphenylsulfonium trifluoromethanesulfonate, and bis(alkylphenyl)iodonium hexafluorophosphate; catalysts containing a Lewis acid, such as zinc chloride, tin chloride, ferric chloride, aluminum chloride, or $BF_3$, as the main component; protonic acids, such as hydrochloric acid and phosphoric acid; amines, such as trimethylamine, triethylamine, triethylenediamine, dimethylbenzylamine, and diazabicycloundecene; imidazoles, such as 2-methylimidazole, 2-ethyl-4-methylimidazole, and 1-cyanoethyl-2-undecylimidazolium trimellitate; bases, such as sodium hydroxide, potassium hydroxide, and potassium carbonate; tin catalysts, such as dibutyltin dilaurate, dioctyltin dilaurate, and dibutyltin octoate; bismuth catalysts, such as tris(2-ethylhexanoate)bismuth and tribenzoyloxybismuth; and zirconium catalysts, such as tetrakis(ethyl acetoacetato)zirconium, 1,1'-isopropylidenezirconocene dichloride, and tetrakis(2,4-pentanedionato)zirconium.

Among these, a bismuth catalyst or a zirconium catalyst is preferred for improving storage stability.

The bismuth-based catalyst is not particularly limited as long as it is a catalyst containing a bismuth element and is a compound that promotes a reaction of an isocyanate with a polyol.

Examples of the bismuth-based catalyst include tris(2-ethylhexanoato)bismuth, tribenzoyloxybismuth, bismuth triacetate, tris(dimethyldithiocarbamato)bismuth, bismuth hydroxide, triphenylbismuth(V) bis(trichloroacetato), tris(4-methylphenyl)oxobismuth(V), and triphenylbis(3-chlorobenzoyloxy)bismuth(V).

Among these, from the viewpoint of catalytic activity, the bismuth-based catalyst is preferably a trivalent bismuth compound and more preferably bismuth carboxylate, a compound represented by a general formula $Bi(OCOR)_3$, where R is a linear or branched alkyl group, a cycloalkyl group, or a substituted or unsubstituted aromatic group. Any one of the bismuth-based catalysts described above may be used alone, or two or more may be used in any combination and ratio.

The zirconium-based catalyst is not particularly limited as long as it is a catalyst containing a zirconium element and is a compound that promotes a reaction of an isocyanate with a polyol.

Examples of the zirconium-based catalyst include cyclopentadienylzirconium trichloride, decamethylzirconocene dichloride, 1,1'-dibutylzirconocene dichloride, 1,1'-isopropylidenezirconocene dichloride, tetrakis(2,4-pentanedionato)zirconium, tetrakis(trifluoro-2,4-pentanedionato)zirconium, tetrakis(hexafluoro-2,4-pentanedionato)zirconium, zirconium butoxide, zirconium-t-butoxide, zirconium propoxide, zirconium isopropoxide, zirconium ethoxide, bis(ethyl acetoacetato)dibutoxyzirconium, tetrakis(ethyl acetoacetato)zirconium, zirconium oxide, barium zirconium oxide, calcium zirconium oxide, zirconium bromide, zirconium chloride, zirconium fluoride, indenyl zirconium dichloride, and zirconium carbonate.

Among these, the zirconium-based catalyst is preferably a compound having an organic ligand from the viewpoint of compatibility with other components, and more preferably an alkoxide or a compound having an acetylacetonate (2,4-pentanedionato) structure. Any one of the zirconium compounds described above may be used alone, or two or more may be used in any combination and ratio.

The bismuth-based catalyst and the zirconium-based catalyst may each be used alone or may be mixed and used.

The amount of a urethane polymerization catalyst to be used is preferably in a range of typically 0.0001 mass% or more, particularly 0.001 mass% or more, typically 10 mass% or less, and particularly 5 mass% or less in terms of the ratio to the matrix resin. Using an excessively small amount of a urethane polymerization catalyst may take too much time for curing. Using an excessively large amount of a urethane polymerization catalyst may make it difficult to control the curing reaction.

The curing can be performed at room temperature by using a urethane polymerization catalyst, but the curing may be performed at an elevated temperature. The temperature at this time is preferably between 40°C and 90°C.

2-4-3. Photocurable Resin

When a photocurable resin is used as the matrix resin, it is necessary to cure it using a photoinitiator for the matrix resin according to the wavelength to be used. Curing during light irradiation would cause a problem in forming and/or adhesion. Thus, it is desirable that the curing reaction is stable at and around room temperature, which is the temperature at which the operation is mainly performed. In view of this, it can be said that catalytic curing with a photoinitiator for the matrix resin is a desirable choice.

Usually, light irradiation produces an active species of either a cation or an anion from the photoinitiator for the matrix resin. Thus, it is considered preferred to select a resin that is cured by these active species and to cure it to form the matrix resin.

Examples of a functional group that reacts with a cation, such as a proton, include an epoxy group and an oxetanyl group. Specific examples of a compound having an epoxy group among the compounds having these groups include polyglycidyl ether compounds of a polyol, such as (poly)ethylene glycol, (poly)propylene glycol, (poly)tetramethylene glycol, trimethylolpropane, and glycerin; alicyclic epoxy compounds having a 4- to 7-membered aliphatic cyclic group, such as 3,4-epoxycyclohexylmethyl-3,4-epoxycyclohexanecarboxylate and 3,4-epoxy-1-methylcyclohexyl-3,4-epoxy-1-methylhexanecarboxylate; bisphenol A-type epoxy compounds; hydrogenated bisphenol A-type epoxy compounds; bisphenol F-type epoxy compounds; and phenol or cresol novolac-type epoxy compounds. Examples of a compound having an oxetanyl group include 2-ethyl-2-oxetanyl ether of bisphenol A and 1,6-bis(2-ethyl-2-oxetanyloxy)hexane, where the description "(poly)ethylene glycol" and the like here refers to both "ethylene glycol" and its polymer "polyethylene glycol".

Examples of a functional group that reacts with an anion include an epoxy group and an episulfide group. Specific examples of a compound having an episulfide group include phenyl episulfide, and a diepisulfide methyl ether of bisphenol A.

The amount of a photoinitiator for the matrix resin to be used in photocuring the matrix resin described above is preferably in a range of typically 0.01 mass% or more, particularly 0.1 mass% or more, typically 1 mass% or less, and particularly 0.5 mass% or less in terms of the ratio to the polymerizable compound. Using an excessively small amount of a photoinitiator for the matrix resin may take too much time for curing. Using an excessively large amount of a photoinitiator for the matrix resin may make it difficult to control the curing reaction.

In particular, when the composition is used as a hologram recording material, it is important that the wavelength used for curing differs from that used for recording, because the composition is also irradiated with light during recording.

The difference in wavelengths is at least 10 nm and preferably 30 nm. The choice of the photoinitiator for the matrix resin can generally be predicted from the absorption wavelength of the initiator.

2-4-4. Content of Matrix Resin

The content of the matrix resin in the composition of the present invention is freely determined as long as it is not inconsistent with the gist of the present invention. For example, when an isocyanate and a polyol are used as the matrix resins, their total content is typically 0.1 mass% or more, preferably 10 mass% or more, more preferably 35 mass% or more, typically 99.9 mass% or less, and preferably 99 mass% or less. Setting this content to not less than the above lower limit value facilitates the formation of a recording layer.

In this case, the ratio of the number of isocyanate-reactive functional groups of the polyol to the number of isocyanate groups of the isocyanate is preferably 0.1 or more, more preferably 0.5 or more, typically 10.0 or less, and preferably 2.0 or less. Setting this ratio within the above range reduces the number of unreacted functional groups and improves the storage stability.

In the composition of the present invention, the content of a urethane polymerization catalyst is preferably determined in view of the reaction rate of the isocyanate with the polyol. The content of the urethane polymerization catalyst is preferably 5 mass% or less, more preferably 4 mass% or less, even more preferably 1 mass% or less, and preferably 0.003 mass% or more.

2-5. Radical Scavenger

In hologram recording, a radical scavenger may be added to accurately fix the interference light intensity pattern as a polymer distribution in a hologram recording medium. The radical scavenger preferably has both a functional group that captures a radical and a reactive group that is fixed to the matrix resin by a covalent bond. Examples of the functional group that captures a radical include a stable nitroxyl radical group.

2-5-1. Type of Radical Scavenger

Examples of the reactive group to be fixed to the matrix resin by a covalent bond include a hydroxy group, an amino group, an isocyanate group, and a thiol group. Examples of such a radical scavenger include a 4-hydroxy-2,2,6,6-tetramethylpiperidin-1-oxyl free radical (TEMPOL), 3-hydroxy-9-azabicyclo[3.3.1]nonane N-oxyl, 3-hydroxy-8-azabicyclo[3.2.1]octane N-oxyl, and 5-hydroxy-2-azatricyclo[3.3.1.1$^{3,7}$]decane N-oxyl (5-HO-AZADO).

2-5-2. Content of Radical Scavenger

Any one of the various radical scavengers described above may be used alone, or two or more may be used in any combination and ratio.

The content of the radical scavenger in the composition of the present invention is preferably 0.5 μmol/g or more, more preferably 1 μmol/g or more, preferably 100 μmol/g or less, and more preferably 50 μmol/g or less, in terms of the molar amount per unit weight of the composition.

An excessively low content of the radical scavenger would tend to reduce the efficiency of scavenging radicals. This would tend to cause a polymer with a low degree of polymerization to diffuse and to increase components that do not contribute to the signal. An excessively high content of the radical scavenger would tend to reduce the polymerization efficiency of a polymer, tending to make signal recording impossible. When two or more radical scavengers are used in combination, it is preferred to adjust their total amount to satisfy the above range.

2-6. Additional Component

The composition of the present invention may contain an additional component in addition to the components described above as long as it is not inconsistent with the gist of the present invention.

Examples of the additional component include plasticizers; dispersants; leveling agents; defoamers; adhesion promoters; optional fillers composed of an organic or inorganic material and/or the like; diffusing agents; wavelength conversion materials, such as pigments; and agents for controlling the recording reaction, such as chain transfer agents, polymerization terminators (polymerization inhibitors), compatibilizers, reaction aids, and sensitizers. Examples of an additional additive that may be required for improving the properties include preservatives, stabilizers, antioxidants, ultraviolet absorbers, and light stabilizers. Any one of these components may be used alone, or two or more may be used in any combination and ratio.

Antioxidant/Light Stabilizer

The composition of the present invention is preferably blended with an antioxidant and/or a light stabilizer to improve thermal yellowing resistance and/or weather resistance of the resulting polymer.

Specific examples of the antioxidant include phenolic antioxidants, such as 2,6-di-t-butylphenol, 2,6-di-t-butyl-p-cresol, n-octadecyl-3-(3',5'-di-t-butyl-4'-hydroxyphenyl)propionate, tetrakis[methylene-3-(3',5'-di-t-butyl-4'-hydroxyphenyl)propionate]methane, triethylene glycol bis[3-(3-t-butyl-5-methyl-4-hydroxyphenyl)propionate], and 1,6-hexanediol bis[3-(3,5-di-t-butyl-4-hydroxyphenyl)propionate]; and phosphorus-based antioxidants, such as triphenyl phosphite, trisisodecyl phosphite, isodecyl diphenyl phosphite, 2-ethylhexyl diphenyl phosphite, tetra(C12-C15 alkyl)-4,4'-isopropylidenediphenyl diphosphite, tris(nonylphenyl)phosphite, tristridecyl phosphite, 2,4,8,10-tetra-tert-butyl-6-[(2-ethylhexan-1-yl)oxy]-12H-dibenzo[d,g][1,3,2]dioxaphosphocin, 3,9-bis(2,6-di-tert-butyl-4-methylphenoxy)-2,4,8,10-tetraoxa-3,9-diphosphaspiro[5.5]undecane, 3,9-dioctadecan-1-yl-2,4,8,10-tetraoxa-3,9-diphosphaspiro[5.5]undecane, and tris(2,4-di-t-butylphenyl)phosphite. These can be used alone, or two or more can be used in combination.

As the antioxidant, a phenolic antioxidant and a phosphorus-based antioxidant are preferably used in combination. Examples of a preferred combination of a phenolic antioxidant and a phosphorus-based antioxidant include a combination of at least one phenolic antioxidant selected from tetrakis[methylene-3-(3',5'-di-t-butyl-4'-hydroxyphenyl)propionate]methane and n-octadecyl-3-(3',5'-di-t-butyl-4'-hydroxyphenyl)propionate, and tris(2,4-di-t-butylphenyl)phosphite as a phosphorus-based antioxidant.

In terms of improving thermal yellowing resistance of the resulting polymer, the content of the antioxidant in the composition of the present invention is preferably from 0.01 to 5 parts by mass, more preferably from 0.05 to 3 parts by mass, and even more preferably from 0.1 to 2 parts by mass per 100 parts by mass of the total amount of the composition.

As the light stabilizer, a hindered amine light stabilizer (HALS) is suitably used. Examples of the hindered amine light stabilizer (HALS) include 2,2,6,6-tetramethyl-4-piperidinyl stearate, 2,2,6,6-tetramethyl-4-piperidyl methacrylate, 1,2,2,6,6-pentamethyl-4-piperidyl methacrylate, bis(2,2,6,6-tetramethyl-1-undecyloxypiperidin-4-yl) carbonate, bis(2,2,6,6-tetramethyl-4-piperidyl) sebacate, bis(1,2,2,6,6-pentamethyl-4-piperidyl) sebacate; ADEKA STAB LA-68 and ADEKA STAB LA-63P (both available from ADEKA Corporation); butane-1,2,3,4-tetracarboxylic acid tetrakis(1,2,2,6,6-pentamethyl-4-piperidinyl) ester, 1,2,3,4-butanetetracarboxylic acid tetrakis(2,2,6,6-tetramethyl-4-piperidinyl) ester; and Tinuvin 111FDL, Tinuvin 123, Tinuvin 144, Tinuvin 152, Tinuvin 249, Tinuvin 292, and Tinuvin 5100 (all available from BASF). These can be used alone, or two or more can be used in combination.

In terms of improving thermal yellowing resistance and/or weather resistance of the resulting polymer, the content of the light stabilizer in the composition of the present invention is preferably from 0.01 to 5 parts by mass, more preferably from 0.05 to 3 parts by mass, and even more preferably from 0.1 to 2 parts by mass per 100 parts by mass of the total amount of the composition.

The antioxidants and/or the light stabilizers can each be used alone, or two or more of them can each be used in combination.

Sensitizer

The composition of the present invention can be blended with a compound that controls excitation of the photopolymerization initiator. Examples of such a compound include sensitizers and sensitization aids.

Any sensitizer selected from various known sensitizers can be used. In general, a colored compound, such as a dye, is often used as the sensitizer to absorb visible and ultraviolet laser light. When a sensitizer is used in a hologram recording medium, although this depends on the wavelength of the laser light to be used for recording and the type of initiator to be used, specific examples of a preferred sensitizer in a system using a green laser include compounds described in JP 05-241338 A, JP 02-000069, JP 02-055446 B, and the like. In a system using a blue laser, specific examples include compounds described in JP 2000-010277 A, JP 2004-198446 A, and the like. Any one of these sensitizers may be used alone, or two or more may be used in any combination and ratio.

When the resulting hologram recording medium is required to be colorless and transparent, a cyanine-based dye is preferably used as the sensitizer. Cyanine-based dyes are generally easily decomposed by light, and thus post exposure is carried out. That is, by leaving the hologram recording medium under indoor light or sunlight for several hours to several days, a cyanine-based dye in the hologram recording medium is decomposed and loses its absorption in the visible region, and a colorless and transparent hologram recording medium is obtained.

The amount of the sensitizer needs to be increased or decreased according to the thickness of a recording layer to be formed but is preferably in a range of typically 0.01 mass% or more and particularly 0.1 mass% or more, and typically 10 mass% or less and particularly 5 mass% or less in terms of the ratio to the photopolymerization initiator described in 2-1. Using an excessively small amount of a sensitizer would reduce initiation efficiency and may take considerable time for recording. Using an excessively large amount of a sensitizer would increase the absorption of light used for recording and reproduction and may make it difficult for light to reach deeper areas. When two or more sensitizers are used in

combination, their total amount is adjusted to satisfy the above range.

Plasticizer

The composition of the present invention may contain a plasticizer to improve the reaction efficiency and adjust the physical properties of a recording layer of a hologram recording medium.

Examples of the plasticizer include phthalic acid esters, such as dioctyl phthalate, diisononyl phthalate, diisodecyl phthalate, and diundecyl phthalate; adipic acid esters, such as bis(2-ethylhexyl) adipate, diisononyl adipate, and din-butyl adipate; sebacic acid esters, such as dioctyl sebacate and dibutyl sebacate; phosphoric acid esters, such as tricresyl phosphate; citric acid esters, such as tributyl acetylcitrate; trimellitic acid esters, such as trioctyl trimellitate; alkoxylated (poly)alkylene glycol esters, such as epoxidized soybean oil, chlorinated paraffin, and acetoxymethoxy propane; and terminally alkoxylated polyalkylene glycols, such as dimethoxypolyethylene glycol.

A plasticizer having a fluorine element as exemplified in JP 6069294 B can also be used. Examples of a plasticizer having a fluorine element include 2,2,2-trifluoroethyl butylcarbamate, bis(2,2,2-trifluoroethyl)-(2,2,4-trimethylhexan-1,6-diyl) biscarbamate, bis(2,2,2-trifluoroethyl)-[4-({[(2,2,2-trifluoroethoxy)carbonyl]amino}-methyl)octan-1,8-diyl] biscarbamate, 2,2,3,3,4,4,5,5,6,6,7,7,8,8,9,9-hexadecafluorononyl butylcarbamate, and 2,2,2-trifluoroethyl phenylcarbamate.

These plasticizers are typically used in a range of 0.01 mass% or more and 50 mass% or less, preferably 0.05 mass% or more and 20 mass% or less in terms of the ratio to the total solid content of the composition of the present invention. The content of the plasticizer less than this range would fail to exhibit the effect of improving reaction efficiency and/or adjusting physical properties. An excessively high content of the plasticizer would reduce the transparency of a recording layer and make plasticizer bleed-out significant.

Leveling Agent

A leveling agent can be used in the composition of the present invention. Examples of the leveling agent include polycarboxylic acid sodium salts, polycarboxylic acid ammonium salts, polycarboxylic acid amine salts, silicon-based leveling agents, acrylic-based leveling agents, ester compounds, ketone compounds, and fluorine compounds. Any one of these may be used alone, or two or more may be used in any combination and ratio.

Chain Transfer Agent

A chain transfer agent can be used in the composition of the present invention. Examples of the chain transfer agent include phosphinate salts, such as sodium phosphite and sodium hypophosphite; mercaptans, such as mercaptoacetic acid, mercaptopropionic acid, 2-propanethiol, 2-mercaptoethanol, and thiophenol; aldehydes, such as acetaldehyde and propionaldehyde; ketones, such as acetone and methyl ethyl ketone; halogenated hydrocarbons, such as trichloroethylene and perchloroethylene; terpenes, such as terpinolene, $\alpha$-terpinene, $\beta$-terpinene, and $\gamma$-terpinene; nonconjugated dienes, such as 1,4-cyclohexadiene, 1,4-cycloheptadiene, 1,4-cyclooctadiene, 1,4-heptadiene, 1,4-hexadiene, 2-methyl-1,4-pentadiene, 3,6-nonadien-1-ol, and 9,12-octadecadienol; linolenic acid and its derivatives, such as linolenic acid, $\gamma$-linolenic acid, methyl linolenate, ethyl linolenate, isopropyl linolenate, and linolenic anhydride; linoleic acid and its derivatives, such as linoleic acid, methyl linoleate, ethyl linoleate, isopropyl linoleate, and linoleic anhydride; eicosapentaenoic acid and its delivatives, such as eicosapentaenoic acid and ethyl eicosapentaenoate; and docosahexaenoic acid and its derivatives, such as docosahexaenoic acid and ethyl docosahexaenoate.

The amount of any of these additives to be used is typically 0.001 mass% or more, particularly 0.01 mass% or more, typically 30 mass% or less, preferably 15 mass% or less, more preferably 10 mass% or less, and particularly preferably 5 mass% or less in terms of the ratio to the total solid content of the composition of the present invention. When two or more additives are used in combination, their total amount is adjusted to satisfy the above range.

2-7. Method for Producing Photosensitive Composition for Hologram Recording

The composition of the present invention may be produced by mixing the components, or by mixing components other than the photopolymerization initiator in advance and adding the photopolymerization initiator immediately before the photopolymerization reaction.

The method for producing the composition containing the photopolymerizable monomer, the matrix resin, and the photopolymerization initiator is not particularly limited, and the order of mixing and the like can also be appropriately adjusted. When the composition contains a component other than the above, the components may be mixed in any combination and order.

The composition of the present invention using an isocyanate and a polyol as the matrix resin can be obtained, for example, by the method described below, but the present invention is not limited to this.

In addition to the photopolymerizable monomer and the photopolymerization initiator, all components other than an isocyanate and a urethane polymerization catalyst are mixed to obtain a photoreactive composition (Liquid A). A mixture of an isocyanate and a urethane polymerization catalyst is used as a Liquid B.

The photoreactive composition (Liquid A) can also be obtained by mixing all components other than the isocyanate with the photopolymerizable monomer and the photopolymerization initiator.

Each liquid is preferably dehydrated and/or degassed. Insufficient dehydration and/or degassing would generate air bubbles during the production of a hologram recording medium and would fail to provide a uniform recording layer. During the dehydration and/or degassing, each liquid may be subjected to heating and/or pressure reduction as long as each component is not damaged.

The composition obtained by mixing the Liquids A and B is preferably produced immediately before forming a hologram recording medium. At this time, a mixing technique known in the art can also be used. When the Liquids A and B are mixed, degassing may be carried out as necessary to remove residual gas. Furthermore, the Liquids A and B are preferably subjected to a filtration process to remove foreign matter and/or impurities, separately or after mixing. In this case, each liquid is more preferably filtered separately.

An isocyanate-functional prepolymer obtained by a reaction of an isocyanate having excess isocyanate groups as an isocyanate with a polyol can also be used as the matrix resin. Furthermore, an isocyanate-reactive prepolymer obtained by a reaction of a polyol having excess isocyanate-reactive functional groups as a polyol with an isocyanate can also be used as the matrix resin.

3. Polymerization Method for Composition of Present Invention

The polymerization method for the composition of the present invention is not particularly limited, but examples include a method of polymerizing by irradiation with an active energy ray and a method of polymerizing by heating along with active energy ray irradiation.

3-1. Photopolymerization Initiation Method (Active Energy Ray)

When photopolymerized, the composition of the present invention is irradiated with an active energy ray.

The active energy ray to be used is preferably an electron beam or light in a wavelength range from ultraviolet to infrared. As the light source, for example, an ultra-high pressure mercury light source or a metal halide light source can be used when the active energy ray is ultraviolet light. When the active energy ray is visible light, a metal halide light source or a halogen light source can be used. When the active energy ray is infrared light, a halogen light source can be used. In addition, a light source, such as a laser or an LED, can also be used.

The irradiation dose of the active energy ray is appropriately set according to the type of light source, the coating film thickness, and the like, but is appropriately set so that the reaction percentage of the total amount of the polymerizable functional groups of the Compound (1) and other polymerizable compounds is preferably 80% or more and more preferably 90% or more. The reaction percentage is calculated from the change in the absorption peak intensity of the polymerizable functional group before and after the reaction by infrared absorption spectroscopy.

After the polymerization by irradiation with an active energy ray, the polymerization may be further advanced by heat treatment or annealing treatment as necessary. The heating temperature at that time is preferably in a range of 80 to 200°C. The heating time is preferably in a range of 10 to 60 minutes.

3-2. Photopolymerization Initiation Method (Combined with Heating)

When heating treatment is used in combination for photopolymerization of the composition of the present invention, the heating temperature is preferably in a range of 80 to 200°C and more preferably in a range of 100 to 150°C. The heating temperature lower than 80°C would require longer heating time, tending to be uneconomical. The heating temperature higher than 200°C would require higher energy cost and longer heating time and cooling time, thus tending to be uneconomical.

4. Polymer

A polymer of the present invention obtained by polymerizing the composition of the present invention will be described below.

4-1. Refractive Index

In general, the overall density is increased by the polymerization reaction, and thus the refractive index of the

polymer tends to be higher than that of its precursor, namely the photopolymerizable monomer. The refractive index of the resulting polymer can be increased by sufficiently advancing the polymerization reaction using a monomer with a high refractive index. Thus, it is considered important to improve the refractive index of the polymer by the molecular structure design of the monomer.

The refractive index is higher when evaluated with short-wavelength irradiation light. However, a sample exhibiting a relatively high refractive index at a short wavelength also shows a relatively high refractive index at a long wavelength, and this relationship is never reversed. Thus, the intrinsic magnitude of the refractive indices of the materials can be compared by evaluating and comparing their refractive indices at a certain wavelength. In the present invention, a value at an irradiation light wavelength of 587 nm was used as a reference.

The refractive indices of the composition of the present invention and the polymer of the present invention are preferably 1.60 or more, more preferably 1.63 or more, particularly preferably 1.65 or more, and most preferably 1.67 or more. The upper limit of the refractive indices of the Compound (1) and the polymer of the present invention is not particularly limited but is typically 2.0 or less.

When the composition of the present invention and the polymer of the present invention are used as a recording layer material of a hologram recording medium, the refractive indices of the Compound (1) and the polymer of the present invention are typically in a range of 1.65 or more and 1.78 or less, and preferably 1.77 or less. The refractive index less than 1.65 would result in low diffraction efficiency and fail to provide sufficient multiplicity. The refractive index larger than 1.78 would increase the difference in the refractive index from that of the matrix resin too much, increasing scattering and thus reducing the transmittance, resulting in requiring more energy during recording and reproduction.

4-2. Glass Transition Temperature

The glass transition temperature of the polymer of the present invention is preferably 90°C or higher, more preferably 100°C or higher, even more preferably 110°C or higher, and particularly preferably 120°C or higher, and preferably 250°C or lower, more preferably 220°C or lower, and even more preferably 200°C or lower. The glass transition temperature lower than this range may change the optical properties from design values in the use environment, possibly not satisfying the heat resistance required for practical use. The glass transition temperature higher than this range would reduce the processability of the polymer, possibly failing to provide a formed article with a good appearance and high dimensional accuracy. Furthermore, this would make the polymer brittle with reduced mechanical strength and may deteriorate the handling properties of a formed article.

5. Optical Material and Optical Component

The composition and the polymer of the present invention have performances, such as high transparency, high refractive index, easy polymerizability, easy processability, high chemical stability, archivability, and low fluorescence, and thus can be applied to various optical materials and optical components.

Examples of the optical materials include optical overcoats, hard coating agents, adhesives for optical members, resins for optical fibers, and acrylic-based resin modifiers.

Examples of the optical components include lenses, filters, diffraction gratings, prisms, light guides, cover glasses for display devices, photosensors, photoswitches, LEDs, light-emitting elements, optical waveguides, light splitters, optical fiber adhesives, substrates for display elements, substrates for color filters, substrates for touch panels, polarizing plates, display backlights, light guide plates, antireflection films, viewing angle expansion films, optical recording, optical shaping, and optical relief printing.

In addition, the composition and the polymer of the present invention can also be used as their layers. Examples include display protective films.

Among these, the composition and the polymer of the present invention can be particularly preferably applied to plastic lenses due to their high-refractive-index properties. Examples of the lenses include imaging lenses for cameras (such as in-vehicle cameras, digital cameras, PC cameras, mobile phone cameras, and surveillance cameras), spectacle lenses, light beam condensing lenses, and light diffusing lenses.

The lens using the composition and the polymer of the present invention can be subjected to physical or chemical treatment, such as surface polishing, antistatic treatment, hard coat treatment, non-reflective coat treatment, and/or dyeing treatment, to improve antireflection, impart high hardness, improve abrasion resistance, improve chemical resistance, impart antifogging properties, or impart fashionability and the like, as necessary.

6. Hologram Recording Medium

A hologram recording medium of the present invention using the composition of the present invention includes a recording layer, and, as necessary, further a support and an additional layer. The hologram recording medium typically has

a support, and the recording layer and the additional layer are laminated on the support to constitute the hologram recording medium. When the recording layer or the additional layer has strength and/or durability required for the medium, the hologram recording medium need not have the support. Examples of the additional layer include a protective layer, a reflective layer, and an antireflection layer (antireflection film).

6-1. Recording Layer

The recording layer of the hologram recording medium of the present invention is a layer formed from the composition of the present invention, and is a layer in which information is recorded. The information is typically recorded as a hologram. As described later in the section on a recording method, a portion of the polymerizable compound (hereinafter described as a polymerizable monomer) contained in the recording layer undergoes a chemical change, such as polymerization, by hologram recording or the like. Thus, in the hologram recording medium after recording, a portion of the polymerizable monomer is consumed and present as a post-reaction compound, such as a polymer.

The thickness of the recording layer is not particularly limited and is appropriately determined in view of the recording method and the like. The thickness of the recording layer is preferably 1 μm or more, more preferably 10 μm or more, preferably 1 cm or less, and more preferably 3 mm or less. Adjusting the thickness of the recording layer to not less than the above lower limit value tends to increase the selectivity of each hologram during multiple recording in the hologram recording medium, which tends to enable a higher degree of multiple recording. Adjusting the thickness of the recording layer to not more than the above upper limit value enables uniform formation of the entire recording layer, which tends to enable multiple recording with uniform diffraction efficiency for each hologram and a high S/N ratio.

The shrinkage percentage of the recording layer due to exposure to light during recording and reproduction of information is preferably 0.25% or less from the viewpoint of recording reproducibility.

6-2. Support

The support is not particularly limited in its detail and any support can be used as long as it has strength and durability required for the hologram recording medium.

The shape of the support is not limited either but is typically formed into a flat plate shape or a film shape.

The material constituting the support is not limited either and may be transparent or opaque.

Examples of the transparent material of the support include organic materials, such as acryl, poly(ethylene terephthalate), poly(ethylene naphthoate), polycarbonate, polyethylene, polypropylene, amorphous polyolefin, polystyrene, polycycloolefin, and cellulose acetate; and inorganic materials, such as glass, silicon, and quartz. Among these, polycarbonate, acryl, polyester, amorphous polyolefin, glass, or the like is preferred, and polycarbonate, acryl, amorphous polyolefin, polycycloolefin, or glass is more preferred.

Examples of the opaque material of the support include metals, such as aluminum; and those obtained by coating the transparent support with a metal, such as gold, silver, or aluminum, or a dielectric, such as magnesium fluoride or zirconium oxide.

The thickness of the support is not particularly limited either but is preferably in a range of 0.05 mm or more and 1 mm or less. The support with a thickness of not less than the above lower limit value can provide the hologram recording medium with mechanical strength and prevent substrate warpage. The support with a thickness of not more than the above upper limit value can provide advantages, such as an increase in the amount of transmitted light and a reduction in the weight and cost of the hologram recording medium.

The surface of the support may be subjected to surface treatment. This surface treatment is typically performed to improve the adhesion between the support and the recording layer. Examples of the surface treatment include subjecting the support to corona discharge treatment, and forming an undercoat layer on the support in advance. Examples of the composition of the undercoat layer include halogenated phenols, partially hydrolyzed vinyl chloride-vinyl acetate copolymers, and polyurethane resins.

The surface treatment of the support may be performed for a purpose other than the improvement of the adhesion. Examples of such treatment include reflective coating treatment for forming a reflective coating layer formed of a metal, such as gold, silver, or aluminum; and dielectric coating treatment for forming a dielectric layer of magnesium fluoride, zirconium oxide, or the like. These layers may be formed in a single layer or two or more layers.

These surface treatments may be provided to control the gas or moisture permeability of the substrate. For example, providing supports that sandwich the recording layer with the function of suppressing the gas or moisture permeability can improve the reliability of the hologram recording medium.

The support may be provided on only one of the upper or lower sides of the recording layer of the hologram recording medium of the present invention, or it may be provided on both sides. In a hologram recording medium in which the supports are provided on both the upper and lower sides of the recording layer, at least one of the supports is transparent so as to transmit an active energy ray (such as excitation light, reference light, or reproduction light).

In a hologram recording medium having a support on one or both sides of the recording layer, a transmission-type or reflection-type hologram can be recorded. In a hologram recording medium in which a support having reflection properties is used on one side of the recording layer, a reflection-type hologram can be recorded.

The support may be provided with a data addressing pattern. The patterning method in this case is not limited. For example, unevenness may be formed on the support itself, a pattern may be formed on a reflective layer described later, or they may be formed by a combination of these methods.

6-3. Protective Layer

The protective layer is a layer for preventing deterioration and the like of the recording and reproduction characteristics of the recording layer. The specific configuration of the protective layer is not limited, and a known configuration can be freely applied. For example, a layer composed of a watersoluble polymer, an organic/inorganic material, and/or the like can be formed as the protective layer.

The position where the protective layer is formed is not particularly limited. The protective layer may be formed, for example, on the recording layer surface, between the recording layer and the support, or on the outer surface side of the support. The protective layer may be formed between the support and another layer.

6-4. Reflective Layer

The reflective layer is formed when the hologram recording medium is configured as a reflection type. In a reflection-type hologram recording medium, the reflective layer may be formed between the support and the recording layer, or on the outer surface of the support. Typically, the reflective layer is preferably present between the support and the recording layer.

A known material can be freely applied as the reflective layer; for example, a metal thin film or the like can be used.

6-5. Antireflection Film

In both transmission-type and reflection-type hologram recording media, an antireflection film may be provided on the side where information light, reference light, and reproduction light are incident and exiting, or between the recording layer and the support. The antireflection film serves to improve the utilization efficiency of light and suppress the generation of noise.

A known antireflection film can be freely used as the antireflection film.

6-6. Method for Producing Hologram Recording Medium

The method for producing the hologram recording medium of the present invention is not limited. For example, the hologram recording medium can be produced by applying the composition of the present invention onto a support without a solvent to form the recording layer. In this case, any coating method can be used. Specific examples include a spray method, a spin coating method, a wire bar method, a dip method, an air knife coating method, a roll coating method, a blade coating method, and a doctor roll coating method.

In forming the recording layer, especially in forming a recording layer with a large film thickness, a method of molding the composition in a mold or a method of applying the composition onto a release film and punching out the mold can also be used. The recording layer may be formed and produced by preparing a coating liquid composed of the composition of the present invention containing a solvent, applying the liquid onto a support, and drying it. Also, in this case, any coating method can be used. For example, the same methods as described above can be employed.

The solvent used in the coating liquid is not limited, and examples include those exemplified in the section "2-3. Solvent". Typically, a solvent that provides sufficient solubility for the components to be used, gives good coating properties, and does not corrode a support, such as a resin substrate, is preferably used. One of the solvents may be used alone, or two or more may be used in any combination and ratio. The amount of the solvent to be used is not limited. However, from the aspects of coating efficiency and handling properties, a coating liquid with a solid content concentration of about 1 to 100 mass% is preferably prepared.

Examples of the solvent include ketone-based solvents, such as acetone, methyl ethyl ketone, methyl isobutyl ketone, cyclohexanone, and methyl amyl ketone; aromatic-based solvents, such as toluene and xylene; alcohol-based solvents, such as methanol, ethanol, propanol, n-butanol, heptanol, hexanol, diacetone alcohol, and furfuryl alcohol; ketone alcohol-based solvents, such as diacetone alcohol and 3-hydroxy-3-methyl-2-butanone; ether-based solvents, such as tetrahydrofuran and dioxane; halogen-based solvents, such as dichloromethane, dichloroethane, and chloroform; cellosolve-based solvents, such as methyl cellosolve, ethyl cellosolve, butyl cellosolve, methyl cellosolve acetate, and ethyl cellosolve acetate; propylene glycol-based solvents, such as propylene glycol monomethyl ether, propylene

glycol monoethyl ether, propylene glycol monobutyl ether, propylene glycol monomethyl ether acetate, propylene glycol monoethyl ether acetate, propylene glycol monobutyl ether acetate, and dipropylene glycol dimethyl ether; ester-based solvents, such as ethyl acetate, butyl acetate, amyl acetate, butyl acetate, ethylene glycol diacetate, diethyl oxalate, ethyl pyruvate, ethyl-2-hydroxybutyrate, ethyl acetoacetate, methyl lactate, ethyl lactate, methyl 2-hydroxyisobutyrate, and methyl 3-methoxypropionate; perfluoroalkyl alcohol-based solvents, such as tetrafluoropropanol, octafluoropentanol, and hexafluorobutanol; high polarity solvents, such as dimethylformamide, dimethylacetamide, N-methylpyrrolidone, and dimethyl sulfoxide; chain hydrocarbon-based solvents, such as n-hexane and n-octane; cyclic hydrocarbon-based solvents, such as cyclohexane, methylcyclohexane, ethylcyclohexane, dimethylcyclohexane, n-butylcyclohexane, tert-butylcyclohexane, and cyclooctane; or their mixed solvents.

Examples of the method for producing the hologram recording medium include a method of producing the hologram recording medium by applying a composition melted by heat to a support, cooling the composition to solidify and form a recording layer; a method of producing the hologram recording medium by applying a liquid composition to a support and curing the composition by thermal polymerization to form a recording layer; and a method of producing the hologram recording medium by applying a liquid composition to a support and curing the composition by photopolymerization to form a recording layer.

The hologram recording medium thus produced can be in the form of a self-standing slab or disk and can be used for three-dimensional image display devices, diffractive optical elements, large-capacity memories, and the like.

In particular, the hologram recording medium of the present invention using the composition of the present invention has a high refractive index modulation and is also useful as an AR glass light guide plate (waveguide plate). Here, AR is an abbreviation for augmented reality.

6-7. Application of Hologram Recording Medium

Large-Capacity Memory Application

Writing (recording) and reading (reproduction) of information in the hologram recording medium of the present invention are both performed by irradiation with light.

In recording information, light capable of inducing a chemical change in the polymerizable monomer, that is, its polymerization and concentration change, is used as object light (also called recording light).

For example, in recording information as a volume hologram, the recording layer is irradiated with the object light together with the reference light to cause the object light and the reference light to interfere with each other in the recording layer. This causes the interference light to induce polymerization and a concentration change of the polymerizable monomer within the recording layer. As a result, interference fringes form a refractive index difference within the recording layer, and a hologram is thereby recorded in the recording layer by the interference fringes recorded within the recording layer.

In reproducing the volume hologram recorded in the recording layer, the recording layer is irradiated with a predetermined reproduction light (typically, a reference light). The reproduction light applied for irradiation is diffracted according to the interference fringes. The diffracted light contains the same information as that of the recording layer. Thus, reading the diffracted light by an appropriate detection means enables reproduction of the information recorded in the recording layer.

The wavelength regions of the object light, the reproduction light, and the reference light are freely selected according to respective applications and may be a visible light region or an ultraviolet region. Among these lights, suitable examples include lasers with excellent monochromaticity and directivity, such as solid lasers of ruby, glass, Nd-YAG, Nd-$YVO_4$, and the like; diode lasers of GaAs, InGaN, GaN, and the like; gas lasers of helium-neon, argon, krypton, excimer, $CO_2$, and the like; and dye lasers having a dye.

The irradiation doses of the object light, the reproduction light, and the reference light are not limited, and the irradiation doses are freely selected as long as they are within ranges that enable recording and reproduction. Extremely small irradiation doses would result in too incomplete a chemical change of the polymerizable monomer, possibly failing to sufficiently exhibit the heat resistance and mechanical properties of the recording layer. On the other hand, extremely large irradiation doses might deteriorate the components of the recording layer (components of the composition of the present invention). Thus, the recording layer is irradiated with the object light, the reproduction light, and the reference light typically in a range of 0.1 $J/cm^2$ or more and 20 $J/cm^2$ or less according to the composition of the composition of the present invention used for forming the recording layer, the type and blending amount of the photopolymerization initiator, and the like.

Examples of the hologram recording system include a polarization collinear hologram recording system and a reference light incident angle multiplexed hologram recording system. When the hologram recording medium of the present invention is used as a recording medium, good recording quality can be provided in any recording system.

AR Glass Light Guide Plate Application (AR Eyeglass Light Guide Plate Application)

A volume hologram is recorded in the hologram recording medium of the present invention in the same manner as in the large-capacity memory application described above.

For the volume hologram recorded in the recording layer, the recording layer is irradiated with a predetermined reproduction light. The reproduction light applied for irradiation is diffracted according to the interference fringes. In this case, even if the wavelength of the reproduction light does not coincide with the wavelength of the recording light, diffraction occurs if the Bragg condition is satisfied for the interference fringes. Thus, recording the corresponding interference fringes according to the wavelength and incident angle of the reproduction light to be diffracted can induce diffraction of the reproduction light across a wide wavelength range. This can expand the display color gamut of the AR glasses.

Recording the corresponding interference fringes according to the wavelength and diffraction angle of the reproduction light can guide the reproduction light incident from outside the hologram recording medium into the hologram recording medium; reflect, split, enlarge, or reduce the reproduction light guided within the hologram recording medium; and emit the reproduction light guided within the hologram recording medium to the outside of the hologram recording medium. This can widen the viewing angle of the AR glasses.

The wavelength regions of the object light and the reproduction light are freely selected according to respective applications and may be a visible light region or an ultraviolet region. Among these lights, suitable examples include the lasers described above. The reproduction light is not limited to a laser or the like, and suitable examples include display devices, such as liquid crystal displays (LCDs) and organic electroluminescence displays (OLEDs).

The irradiation doses of the object light, the reproduction light, and the reference light are not limited, and the irradiation doses are freely selected as long as they are within ranges that enable recording and reproduction. Extremely small irradiation doses would result in too incomplete a chemical change of the polymerizable monomer, possibly failing to sufficiently exhibit the heat resistance and mechanical properties of the recording layer. On the other hand, extremely large irradiation doses might deteriorate the components of the recording layer (components of the composition of the present invention). Thus, the recording layer is irradiated with the object light, the reproduction light, and the reference light typically in a range of 0.1 J/cm$^2$ or more and 20 J/cm$^2$ or less according to the composition of the composition of the present invention used for forming the recording layer, the type and blending amount of the photopolymerization initiator, and the like.

6-8. About Performance Index of Hologram Recording Medium

The performance of the hologram recording medium is indicated by total $\Delta n$, which is calculated using the sum of diffraction efficiencies over the entire multiplex recording. For a transmission hologram, the diffraction efficiency of the hologram is given by the ratio of the intensity of the diffracted light to the sum of the transmitted and diffracted light intensities. From the resulting diffraction efficiencies, $\Delta n$ is calculated using the following equation according to Coupled Wave Theory (H. Kogelnik, The Bell System Technical Journal (1969), 48, 2909 - 2947), and the sum over the entire multiplex recordings is defined as total $\Delta n$.

[Equation 1]

$$\eta = \sin^2\left(\frac{\pi \cdot T \cdot \Delta n}{\lambda \cdot \cos\theta}\right)$$

$$total\Delta n = \sum \Delta n$$

where $\eta$ is the diffraction efficiency, T is the thickness of the medium, $\lambda$ is the wavelength of the reference light, and $\theta$ is the incident angle of the reference light.

For a large-capacity memory, a higher total $\Delta n$ means that the hologram recording medium can record more information per unit volume, which is preferred. For AR glass applications, the hologram recording medium with a higher total $\Delta n$ can brightly deliver the projected image from the projector to the pupil, reduce the power consumption, and widen the viewing angle, which are preferred.

Examples

Hereinafter, the present invention will be described in more detail by examples. The present invention is not limited to the following examples, as long as it does not depart from the gist of the present invention.

Raw Materials Used

Raw materials for compositions used in examples and comparative examples are as follows.

Isocyanate

- DURANATE (trade name) TSS-100: hexamethylene diisocyanate-based polyisocyanate (NCO 17.6%) (available from Asahi Kasei Corporation)

Polyols

- PLACCEL PCL-205U: polycaprolactone diol (molecular weight 530) (available from Daicel Corporation)
- PLACCEL PCL-305: polycaprolactone triol (molecular weight 550) (available from Daicel Corporation)

Photopolymerization Initiator

- HLI02: methyl 1-(9-ethyl-6-cyclohexanoyl-9H-carbazol-3-yl)-1-(O-acetyloxime) glutarate

Radical scavenger

- TEMPOL: 4-hydroxy-2,2,6,6-tetramethylpiperidin-1-oxyl free radical (available from Tokyo Chemical Industry Co., Ltd.)

Urethane Polymerization Catalyst

- Solution of tris(2-ethylhexanoate)bismuth in octylic acid (active ingredient amount 56 mass%)

Example 1

Production of Compound M-1

A compound M-1 was produced by the following synthesis method.

[Chem. 15]

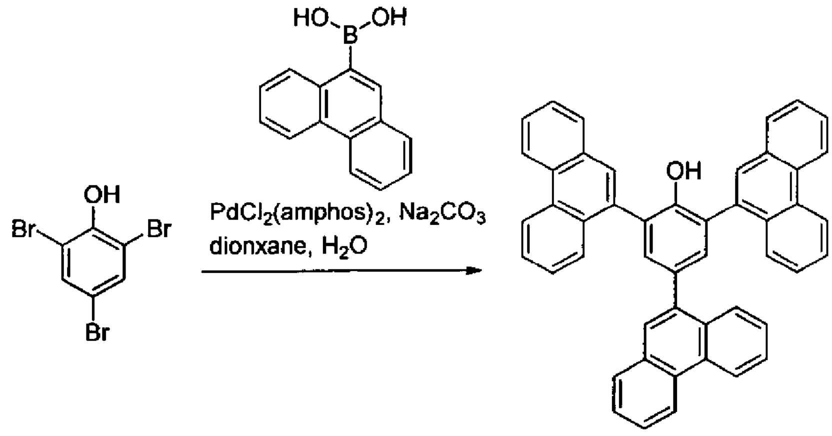


Compound S-1

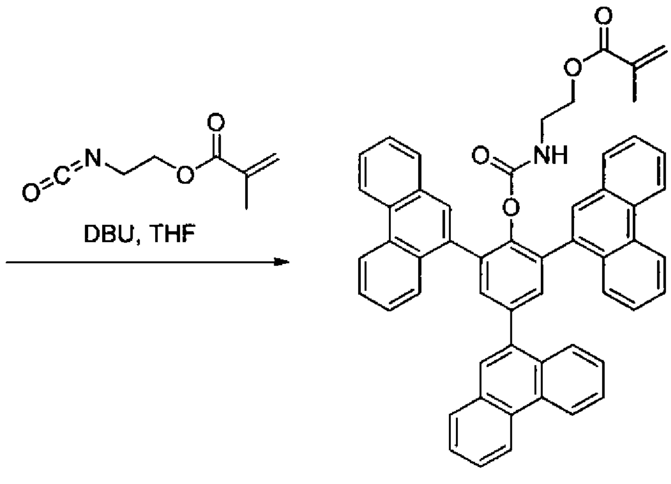


Compound M-1

2,4,6-Tribromophenol (2.3 g), phenanthrene-9-boronic acid (5.8 g), and sodium carbonate (3.5 g) were dissolved in 100 mL of dioxane and 25 mL of water, and the solution was degassed by passing nitrogen gas through the solution. To the reaction solution, 10 mg of dichlorobis[di-t-butyl(p-dimethylaminophenyl)phosphino]palladium(II) was added, and nitrogen gas was further passed through the solution for 5 minutes. Under a nitrogen atmosphere, the reaction solution was heated and stirred under reflux for 5 hours. After cooling to room temperature, 100 mL of ethyl acetate and 50 mL of water were added, and phase separation operation was performed. The resulting organic phase was washed with an aqueous sodium hydrogen carbonate solution. After drying the organic phase, the resulting solid was washed with hexane. The solid was dried in a vacuum dryer, and 4.4 g of a crude product of a compound S-1 was obtained.

NMR measurement data of the compound S-1 were as follows.

$^1$H-NMR (400 MHz, CDCl$_3$, δ, ppm) 8.84 - 8.66 (Ar, 6H), 8.32 (dd, Ar, 1H), 8.11 (dd, Ar, 1H), 8.07 (dd, Ar, 1H), 8.04 - 7.86 (Ar, 8H), 7.75 - 7.57 (Ar, 12H), 5.18 - 5.13 (OH, 1H)

The compound S-1 (4.4 g), 2-isocyanatoethyl acrylate (0.4 g), and THF (10 mL) were mixed. Diazabicycloundecene (0.01 g) was added to the mixture, and the mixture was stirred for 3 hours. After completion of the reaction, the reaction liquid was poured into 50 mL of an aqueous ammonium chloride solution and extracted with 200 mL of ethyl acetate. Then, the extract was washed with 100 mL of a saturated sodium chloride solution, dried over anhydrous magnesium sulfate, filtered, and concentrated. The resulting crude product was purified by column chromatography, and 3.4 g of a compound M-1 was obtained.

NMR measurement data of the compound M-1 were as follows.

$^1$H NMR (400MHz, CDCl$_3$, δ, ppm) 8.81 - 8.66 (Ar, 6H), 8.33 - 8.26 (Ar, 1H), 8.13 - 8.01 (Ar, 2H), 7.99 - 7.85 (Ar, 6H), 7.84 - 7.78 (Ar, 2H), 7.73 - 7.57 (Ar, 12H), 5.67 - 5.54 (C=CH$_2$, 1H), 5.34 - 5.26 (C=CH$_2$, 1H), 4.28 - 3.83(NH, 1H), 3.29 - 2.82 (CH$_2$, 2H), 2.78 - 2.13 (CH$_2$, 2H), 1.67 - 1.58 (Me, 3H)

Production of Compound M-2

A compound M-2 was produced by the following synthesis method.

[Chem. 16]

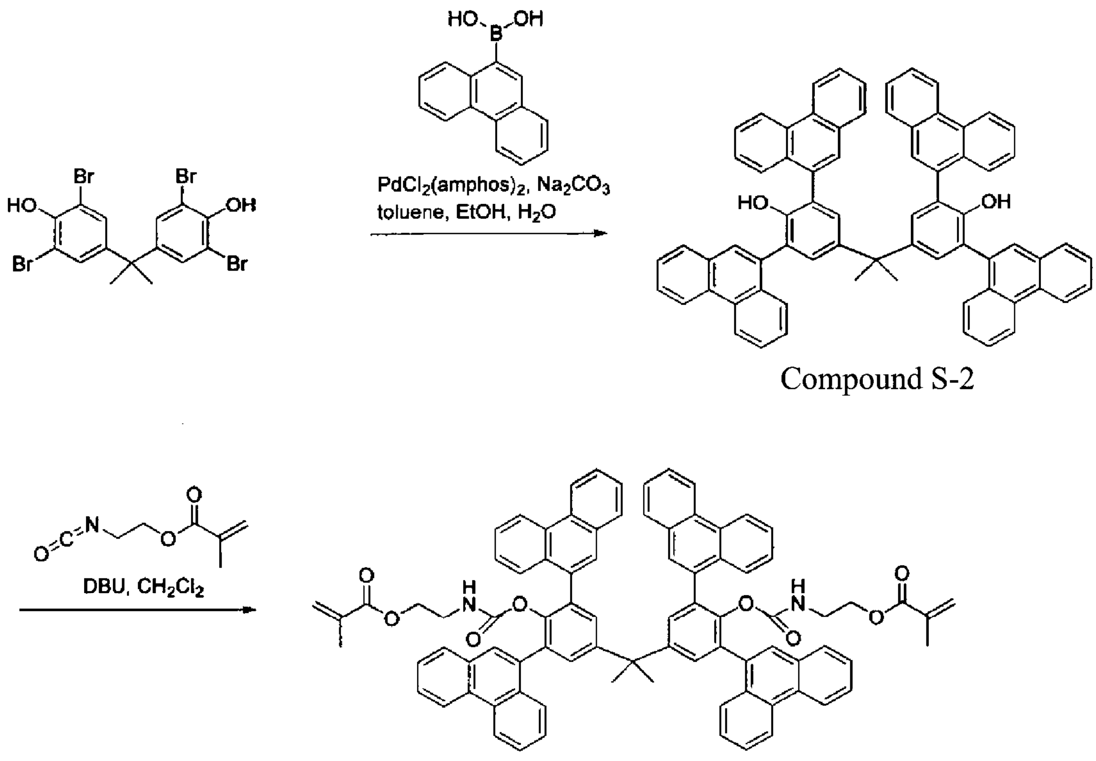


Compound S-2

Compound M-2

Tetrabromobisphenol A (10.0 g), phenanthrene-9-boronic acid (18.1 g), and sodium carbonate (9.9 g) were suspended in 250 mL of toluene, 250 mL of ethanol, and 125 mL of water, and the suspension was degassed by passing nitrogen gas through the suspension. To the reaction solution, 1.4 mg of dichlorobis[di-t-butyl(p-dimethylaminophenyl)phosphino]palladium(II) was added, and nitrogen gas was further passed through the solution for 10 minutes. Under a nitrogen atmosphere, the reaction solution was heated and stirred under reflux for 4 hours. After cooling to room temperature, 100 mL of water was added, and the mixture was extracted with toluene. The organic phase was dried over sodium sulfate, and the resulting organic phase was concentrated. 19.9 g of a crude product of a compound S-2 was obtained by the concentration.

NMR measurement data of the compound S-2 were as follows.

$^1$H-NMR (400 MHz, $CDCl_3$, $\delta$, ppm) 8.81 - 8.67 (Ar, 8H), 7.94 - 7.31 (Ar, 32H), 4.92 - 4.87 (OH, 2H), 1.91 - 1.76 (Me, 6H)

Under a nitrogen gas atmosphere, the crude product (15.7 g) of the compound S-2, 2-isocyanatoethyl methacrylate (5.3 g), and dichloromethane (100 mL) were mixed. Diazabicycloundecene (20.0 mg) was added to the mixture, and the mixture was stirred at room temperature. After completion of the reaction, 8 g of neutral silica gel was added to the reaction liquid, and the mixture was stirred at room temperature for 30 minutes. Then, the silica gel and a solid component were separated by filtration, and the solid was washed with dichloromethane/ethyl acetate (10:1). The resulting organic phase was concentrated, then dissolved in dichloromethane (30 mL), and added dropwise to 300 mL of methanol cooled to 0°C. The resulting solid was filtered, washed with a small amount of cold methanol, then dried in a vacuum dryer, and 14.5 g of a compound M-2 was obtained.

NMR measurement data of the compound M-2 were as follows.

$^1$H-NMR (400 MHz, $CDCl_3$, $\delta$, ppm) 8.82 - 8.61 (Ar, 8H), 8.01 - 7.51 (Ar, 28H), 7.44 - 7.18 (Ar, 4H), 5.62 - 5.48 (C=$CH_2$, 2H), 5.32 - 5.19 (C=$CH_2$, 2H), 4.28 - 3.78 (NH, 2H), 3.33 - 2.73 ($CH_2$, 4H), 2.73 - 2.05 ($CH_2$, 4H), 1.98 - 1.79 (Me, 6H), 1.62 - 1.52 (Me, 6H)

Production of Hologram Recording Medium

In 2.51 g of DURANATE (trade name) TSS-100, 0.2938 g of a mixture of the compound M-1 (0.1789 g) and the compound M-2 (0.1149 g) (molar ratio 90:10) as polymerizable monomers, 0.0096 g of the photopolymerization initiator HLI02, and 3.30 mg of the radical scavenger TEMPOL were dissolved, and this was used as Liquid A.
Separately, 1.74 g of PLACCEL PCL-205U and 0.75 g of PLACCEL PCL-305 were mixed (PLACCEL PCL-205U:PLACCEL PCL-305 = 70:30 (mass ratio)), and 0.2 mg of the solution of tris(2-ethylhexanoate)bismuth in octylic acid was dissolved in the mixture, and this was used as Liquid B.
After Liquids A and B were separately degassed for 2 hours under reduced pressure at room temperature or 45°C, 2.38 g of Liquid A and 2.12 g of Liquid B were mixed under stirring, and the mixture was further degassed in vacuum for several minutes.
Subsequently, the liquid mixture degassed in vacuum was poured onto a slide glass on which spacer sheets with a thickness of 0.5 mm were placed on two opposite end sides. Another slide glass was put on them, and the periphery was fixed with a clip. The slide glasses were heated at 80°C for 24 hours, and a hologram recording medium was prepared as a sample for evaluation. This sample for evaluation is a recording layer with a thickness of 0.5 mm formed between the slide glasses as covers.

Hologram Recording and Evaluation

Using the hologram recording medium prepared as a sample for evaluation, a hologram was recorded and the hologram recording performance of the hologram recording medium was evaluated by the procedures described below.
The hologram was recorded as a two-beam plane wave hologram using a semiconductor laser with a wavelength of 405 nm and a light exposure apparatus illustrated in FIG. 1 at an exposure power density of 10.2 $mW/cm^2$ per beam. The medium was rotated from -22.5° to 22.5° for angle multiplex recording at the same position. The diffraction efficiency was measured for each multiplex recording. From the obtained diffraction efficiencies, $\Delta n$ was calculated, and the sum over the entire multiplex recordings was defined as total $\Delta n$.
This will be described in detail below.

Hologram Recording

FIG. 1 is a configuration diagram illustrating an overview of the apparatus used for hologram recording.
In FIG. 1, S is a sample of the hologram recording medium, and M1 to M3 each represent a mirror. PBS represents a polarizing beam splitter. L1 represents a laser light source for recording light, emitting light with a wavelength of 405 nm (a single-mode laser ("L1" in FIG. 1), available from TOPTICA Photonics, capable of producing light with a wavelength at or near 405 nm). L2 represents a laser light source for reproduction light, emitting light with a wavelength of 633 nm. PD1, PD2, and PD3 represent photodetectors. Reference numeral 1 represents an LED unit.
As illustrated in FIG. 1, light with a wavelength of 405 nm was split by the polarizing beam splitter ("PBS" in the figure), and the two beams were intersected on the recording surface so that the two beams formed an angle of 59.3°. At this time, the recording surface was irradiated with the two beams so that the bisector of the angle formed by the two beams was perpendicular to the recording surface, and the vibration planes of the electric field vectors of the two beams obtained by splitting were perpendicular to the plane containing the two intersecting beams.
After hologram recording, a He-Ne laser capable of emitting light with a wavelength of 633 nm (V05-LHP151 available from Melles Griot Inc., "L2" in the figure) was used. The hologram recording medium was irradiated with the light at an angle of 50.7°, and the diffracted light was detected using a photodiode and a photosensor amplifier (S2281 and C9329 available from Hamamatsu Photonics K.K., "PD1" in the figure) to determine whether the hologram was correctly recorded.

Measurement of Diffraction Efficiency

The angle at which the sample was moved with respect to the optical axis (the angle formed by the bisector of the interior angle at the point where the two beams, that is, the incident light from mirrors M1 and M2 in FIG. 1, intersect, and the normal from the sample) was varied from -22.5° to 22.5° in increments of 0.3°, and 151 multiplex recordings were performed.
After the multiplex recordings, the LED unit (reference numeral 1 in the figure, central wavelength 405 nm) was turned on for a certain time to consume the remaining initiator and monomer. This process is called post exposure. The power of the LED was set to 30 $mW/cm^2$, and irradiation was performed so that the cumulative energy was 3.6 $J/cm^2$.
The diffraction efficiency of the hologram is given by the ratio of the intensity of the diffracted light to the sum of the transmitted and diffracted light intensities. The sample was irradiated with the light from the mirror M1 in FIG. 1 (wavelength

405 nm), and the diffraction efficiencies from the angle -23° to 23° were measured. From the resulting diffraction efficiencies, $\Delta n$ is calculated using the following equation according to Coupled Wave Theory (H. Kogelnik, The Bell System Technical Journal (1969), 48, 2909 - 2947), and the sum over the entire multiplex recordings was determined as total $\Delta n$.

[Equation 2]

$$\eta = \sin^2\left(\frac{\pi \cdot T \cdot \Delta n}{\lambda \cdot \cos\theta}\right)$$

$$total\Delta n = \sum \Delta n$$

where $\eta$ is the diffraction efficiency, T is the thickness of the medium, $\lambda$ is the wavelength of the reference light, and $\theta$ is the incident angle (29.65°) of the reference light.

Using a plurality of prepared samples, evaluation was performed multiple times by varying irradiation energy conditions, such as by increasing or decreasing irradiation energy at the recording initial stage and total irradiation energy, to search for conditions that would almost completely consume the polymerizable monomer (total $\Delta n$ almost reaches equilibrium in multiplex recordings), and total $\Delta n$ was maximized. Then, the resulting maximum value was determined as the total $\Delta n$ of the medium. The evaluation results are shown in Table 2 below.

Example 2

A hologram recording medium was prepared and evaluated in the same manner as in Example 1 except for using a mixture of the compound M-1 (0.2264 g) and the compound M-2 (0.0379 g) (molar ratio 90:10) as the polymerizable monomer.

Comparative Example 1

A hologram recording medium was prepared and evaluated in the same manner as in Example 1 except for using the compound M-1 (0.2515 g) alone as the polymerizable monomer.

Comparative Example 2

A hologram recording medium was prepared and evaluated in the same manner as in Example 1 except for using the compound M-2 (0.3821 g) alone as the polymerizable monomer.

Measurement of Refractive Index

The refractive indices of the compounds M-1 and M-2, the photopolymerizable monomers produced in the examples, were measured by the following method. The results are shown in Table 1.

Test solutions were prepared by dissolving the sample in a mixed solution of 3-phenoxybenzyl acrylate and trimethylolpropane trimethacrylate in a mass ratio of 4:1 so as to have predetermined concentrations. Two test solutions with sample concentrations of 10 mass% and 20 mass% were prepared.

The refractive index of each test solution was measured with a Kalnew Precision Refractometer (product name KPR-2000, available from Shimadzu Corporation). The temperature of the test solutions was set at 23°C, and the helium lamp d line (587.6 nm) was used as the measurement wavelength. Based on the measurement results, a calibration curve showing the correlation between the sample concentration and the refractive index was created, and the refractive index at the sample concentration of 100 mass% was determined from the resulting calibration curve and taken as the refractive index of the sample.

[Table 1]

| Photopolymerizable monomer | Refractive Index |
|---|---|
| M-1 | 1.6898 |
| M-2 | 1.6923 |

As can be seen from Table 1, the compounds M-1 and M-2 produced in the examples both had a refractive index

of 1.65 or more and were excellent high-refractive-index materials.

Archivability

The hologram recording medium with the measured total Δn was heated and stored at 75°C in dry air for 100 hours, and the total Δn after heating was measured to calculate the Δn retention percentage before and after heating. Based on this retention percentage, a sample with a retention percentage of 95% or more was evaluated as ◎; a sample with a retention percentage of less than 95% and 85% or more as ◦; a sample with a retention percentage of less than 85% and 75% or more as △; and a sample with a retention percentage of less than 75% as ×. The results are shown in Table 2.

Fluorescence Intensity

The hologram recording media other than the hologram recording media with the measured total Δn were irradiated with light from the LED unit (reference numeral 1 in the figure, central wavelength 405 nm) at a light power of 80 mW/$cm^2$ so that the light energy reached 48 J/$cm^2$. Thereafter, the fluorescence intensity was measured using a fluorescence spectrophotometer (F-7000 available from Hitachi High-Tech Science Corporation). The fluorescence intensity was measured under conditions of an excitation wavelength of 450 nm, a fluorescence measurement wavelength range of 465 nm to 700 nm, and a measurement wavelength interval of 0.2 nm. As reference data for the apparatus, the fluorescence intensity of bare slide glasses of the same type used for the hologram recording medium was subtracted from that of the hologram recording medium. The integrated value of the fluorescence intensity over the entire measurement range was determined as the integrated fluorescence intensity. A sample with an integrated fluorescence intensity of less than 7000 was evaluated as ○, and a sample with an integrated fluorescence intensity of 7000 or more as ×. The results are shown in Table 2.

[Table 2]

| | | Example 1 | Example 2 | Comparative Example 1 | Comparative Example 2 |
|---|---|---|---|---|---|
| Monofunctional photopolymerizable monomer | | M-1 (70) | M-1 (90) | M-1 (100) | - |
| Polyfunctional photopolymerizable monomer | | M-2 (30) | M-2 (10) | - | M-2 (100) |
| Total Δn before heating | | 0.0244 | 0.0240 | 0.0223 | 0.0191 |
| Total Δn after heating at 75°C for 100 h | | 0.0234 | 0.0209 | 0.0120 | 0.0191 |
| Archivability | Δn Retention percentage (%) | 96 | 87 | 54 | 100 |
| | Evaluation | ◎ | ○ | × | ◎ |
| Fluorescence intensity | Measured value | 5355 | 5163 | 7886 | 7389 |
| | Evaluation | ○ | ○ | × | × |

As shown in Table 2, in Comparative Example 1, in which M-1, a monofunctional photopolymerizable monomer of the Compound (1), was used alone as a photopolymerizable monomer, the total Δn of 0.0223 exhibited by the hologram recording medium before heating decreased to 0.0120 after heating, resulting in a Δn retention percentage of 54%.

On the other hand, in Examples 1 and 2 of the present invention, in which a monofunctional photopolymerizable monomer including the Compound (1) and a polyfunctional photopolymerizable monomer were used in combination, the hologram recording media had a total Δn of 0.024 or more before heating and a Δn retention percentage exceeding 85% after heating.

In addition, regarding fluorescence intensity, the integrated fluorescence intensity was 7000 or more in Comparative Examples 1 and 2, whereas the integrated fluorescence intensity was less than 5500 in Examples 1 and 2, which is significantly lower than in the comparative examples, in which the polymerizable monomer was used alone.

In the optical element applications of an AR glass light guide plate, the hologram recording medium with a higher total Δn can project a brighter image and provide a wider viewing angle. In the memory applications, the improved total Δn can increase the recording capacity. In addition, higher archivability enables these hologram recording media with a high total Δn to continue to exhibit the performance described above for a long period. Compared with the comparative examples, the examples of the present study demonstrated significantly higher archivability. Thus, the photosensitive composition for hologram recording of the present invention can be said to be excellent.

Furthermore, while the hologram recording medium is required to have high transparency, turbidity or noise due to mixing and generation of insoluble matter leads to formation of unintended interference fringes during hologram

recording, leading to reduced performance of the hologram recording medium. In particular, in the AR glass waveguide plate applications, such unintended light scattering reduces light utilization efficiency and aesthetic properties. Moreover, when insoluble matter is deposited on the waveguide plate over time, the absorption intensity of the guided light also changes over time, thus leading to reduced performance stability of the waveguide plate. Thus, using the composition of the present invention capable of suppressing the fluorescence phenomenon due to the phosphor generally produced as a byproduct along with the progress of photopolymerization of the polymerizable monomer enables production of an AR glass light guide plate with excellent light utilization efficiency, aesthetic properties, and long-term performance stability.

From the above, the composition of the present invention used in the examples can be said to be superior to the compounds of the comparative examples.

Although the present invention has been described in detail using specific embodiments, it is apparent to those skilled in the art that various modifications can be made within the scope where the effects of the present invention are achieved.

The present application is based on JP 2023-053748 filed on March 29, 2023, which is incorporated by reference in its entirety.

Reference Signs List

S: Hologram recording medium
M1, M2, M3: Mirror
L1: Semiconductor laser light source for recording light
L2: Laser light source for reproduction light
PD1, PD2, PD3: Photodetector
PBS: Polarizing beam splitter
1: LED unit

## Claims

1. A photosensitive composition for hologram recording, the photosensitive composition comprising a photopolymerization initiator and at least two different photopolymerizable monomers that are a combination of a monofunctional photopolymerizable monomer and a polyfunctional photopolymerizable monomer, wherein at least one of the photopolymerizable monomers is a compound selected from a compound represented by Formula (1-1) and a compound represented by Formula (1-2):

[Chem. 1]

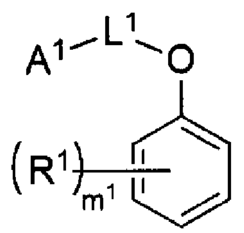

(1-1)

where in Formula (1-1), $A^1$ represents a photopolymerizable group;
$L^1$ represents a single bond or a divalent linking group that may be branched;
$R^1$ represents a fused aromatic ring group that may have a substituent;
$m^1$ is an integer of 2 to 5, and a plurality of $R^1$s may be identical or different; and
a benzene ring having $R^1$ in Formula (1-1) may further have a substituent in addition to $A^1$-$L^1$-O and $R^1$;

[Chem. 2]

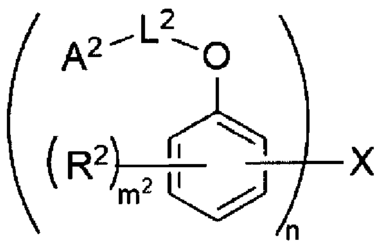

(1-2)

where in Formula (1-2), $A^2$ represents a photopolymerizable group;
$L^2$ represents a single bond or a divalent linking group that may be branched;
$R^2$ represents a fused aromatic ring group that may have a substituent;
$m^2$ is an integer of 2 to 4, and a plurality of $R^2$s may be identical or different;
n represents an integer of 2 to 4;
when n is 2, X represents a single bond or a divalent group selected from the group consisting of structures represented by Formulas (1a) to (1g);
when n is 3, X represents a trivalent organic group;
when n is 4, X represents a carbon atom or a silicon atom;
$A^2$, $L^2$, $R^2$, and $m^2$, each present in multiple numbers in Formula (1-2), may each be identical or different; and a benzene ring having $R^2$ in Formula (1-2) may further have a substituent in addition to $A^2$-$L^2$-O, $R^2$, and X;

[Chem. 3]

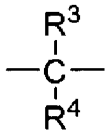

(1a)

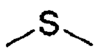

(1b)

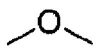

(1c)

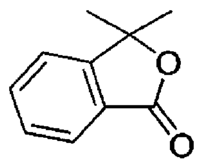

(1d)

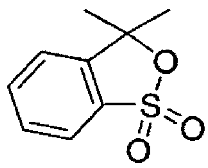

(1e)

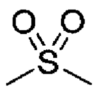

(1f)

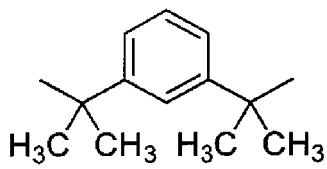

(1g)

where in Formula (1a), $R^3$ and $R^4$ each independently represent a hydrogen atom or an alkyl group having 1 to 4 carbons.

2. The photosensitive composition for hologram recording according to claim 1, wherein n is 2.

3. The photosensitive composition for hologram recording according to claim 1, wherein $m^1$ and $m^2$ each are 2 or 3.

4. The photosensitive composition for hologram recording according to claim 1, wherein $A^1$ and $A^2$ each are a (meth) acryloyl group or an allyl group.

5. The photosensitive composition for hologram recording according to claim 1, wherein the fused aromatic rings of $R^1$ and $R^2$ each are any one of a naphthalene ring, a phenanthrene ring, a dibenzothiophene ring, and a thianthrene ring.

6. The photosensitive composition for hologram recording according to claim 1, wherein at least one of the monofunctional photopolymerizable monomers contains a compound represented by Formula (1-1), and at least one of the polyfunctional photopolymerizable monomers contains a compound represented by Formula (1-2).

**7.** A hologram recording medium comprising the photosensitive composition for hologram recording described in any one of claims 1 to 6.

**8.** A polymer formed by polymerization of the photosensitive composition for hologram recording described in any one of claims 1 to 6.

**9.** An optical material comprising the polymer described in claim 8.

**10.** An optical component comprising the polymer described in claim 8.

**11.** A large-capacity memory comprising the hologram recording medium described in claim 7.

**12.** An optical element obtained by hologram recording in the hologram recording medium described in claim 7.

**13.** An AR light guide plate comprising the optical element described in claim 12.

**14.** AR glasses comprising the optical element described in claim 12.

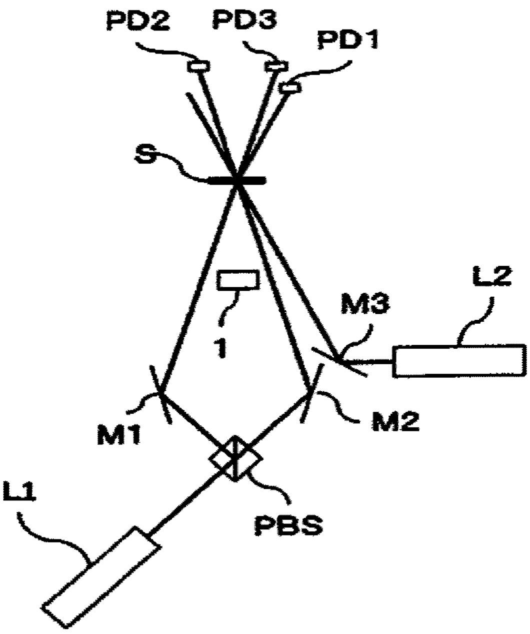


FIG. 1

## INTERNATIONAL SEARCH REPORT

International application No.
**PCT/JP2024/012676**

**A. CLASSIFICATION OF SUBJECT MATTER**

***G11B 7/24044***(2013.01)i; ***C07C 271/48***(2006.01)i; ***C08F 20/30***(2006.01)i; ***C08F 20/34***(2006.01)i; ***C08F 20/38***(2006.01)i; ***G02B 5/32***(2006.01)i; ***G03H 1/02***(2006.01)i; ***G11B 7/0065***(2006.01)i; ***G11B 7/245***(2006.01)i
FI: G11B7/24044; C07C271/48; C08F20/30; C08F20/34; C08F20/38; G02B5/32; G03H1/02; G11B7/0065; G11B7/245

According to International Patent Classification (IPC) or to both national classification and IPC

**B. FIELDS SEARCHED**

Minimum documentation searched (classification system followed by classification symbols)

G11B7/24044; C07C271/48; C08F20/30; C08F20/34; C08F20/38; G02B5/32; G03H1/02; G11B7/0065; G11B7/245

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2005-114849 A (MITSUBISHI CHEMICAL CORPORATION) 28 April 2005 (2005-04-28) paragraphs [0003], [0007]-[0010], [0018]-[0019], [0043]-[0044] | 1-14 |
| A | WO 2019/167947 A1 (SONY CORPORATION) 06 September 2019 (2019-09-06) paragraph [0097] | 1-14 |
| A | WO 2020/121653 A1 (SONY GROUP CORPORATION) 18 June 2020 (2020-06-18) paragraphs [0028]-[0030] | 1-14 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 May 2024** | **11 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/012676**

| Patent document cited in search report | Publication date (day/month/year) | Patent family member(s) | Publication date (day/month/year) |
| --- | --- | --- | --- |
| JP 2005-114849 A | 28 April 2005 | (Family: none) | |
| WO 2019/167947 A1 | 06 September 2019 | US 2021/0040061 A1<br>paragraph [0075]<br>CN 111741985 A | |
| WO 2020/121653 A1 | 18 June 2020 | US 2022/0013142 A1<br>paragraphs [0071]-[0074]<br>EP 3896530 A1<br>CN 113168129 A<br>KR 10-2021-0102237 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 4185939 A
- JP 2013510204 T
- WO 2008123094 A
- WO 2018043593 A
- JP S59152396 A
- JP S61151197 A
- JP H05230189 A
- JP 2000204284 A
- JP 2000119306 A
- JP 2001220526 A
- JP 2001310937 A
- JP 3737306 B
- JP 5241338 A
- JP 2000069 A
- JP 2055446 B
- JP 2000010277 A
- JP 2004198446 A
- JP 6069294 B
- JP 2023053748 A


### Non-patent literature cited in the description


- **H. KOGELNIK**. *The Bell System Technical Journal*, 1969, vol. 48, 2909-2947